(19) Europäisches Patentamt
European Patent Office
Office européen des brevets

(11) EP 4 567 863 A1

(12) EUROPEAN PATENT APPLICATION
published in accordance with Art. 153(4) EPC

(43) Date of publication:
**11.06.2025 Bulletin 2025/24**

(21) Application number: **23850012.8**

(22) Date of filing: **28.07.2023**

(51) International Patent Classification (IPC):
***H01L 21/304*** (2006.01) ***B24B 37/00*** (2012.01)
***C09G 1/02*** (2006.01) ***C09K 3/14*** (2006.01)

(52) Cooperative Patent Classification (CPC):
**B24B 37/00; C09G 1/02; C09K 3/14; H01L 21/304**

(86) International application number:
**PCT/JP2023/027729**

(87) International publication number:
**WO 2024/029457 (08.02.2024 Gazette 2024/06)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **05.08.2022 JP 2022125594**

(71) Applicant: **Fujimi Incorporated**
**Kiyosu-shi, Aichi 452-8502 (JP)**

(72) Inventors:
- **KOMOTO, Yukari**
  **Kiyosu-shi, Aichi 452-8502 (JP)**
- **ICHITSUBO, Taiki**
  **Kiyosu-shi, Aichi 452-8502 (JP)**

(74) Representative: **Grünecker Patent- und Rechtsanwälte**
**PartG mbB**
**Leopoldstraße 4**
**80802 München (DE)**

# (54) POLISHING COMPOSITION

(57) Provided is a polishing composition that contains a water-soluble polymer and can offer a high-grade surface along with maintaining a polishing removal rate. The polishing composition contains silica particles (A) as an abrasive, a basic compound (B), a modified polyvinyl alcohol-based polymer (C1) as a water-soluble polymer (C), and a chelating agent (D), wherein the modified polyvinyl alcohol-based polymer (C1) has an etching rate of 20 nm/h or less based on predetermined etching rate measurement.



Processed by Luminess, 75001 PARIS (FR)

## Description

[Technical Field]

The present invention relates to a polishing composition. The application claims the priority based on Japanese Patent Application No. 2022-125594, filed on August 5, 2022, the content of which is herein incorporated by reference in its entirety.

[Background Art]

A surface of a material such as metal, semimetal, non-metal, or an oxide thereof has been finely polished with a polishing composition. For example, a surface of a silicon wafer used as a component of a semiconductor device or the like is generally finished into a high-grade mirror plane via a lapping step (rough polishing step) and a polishing step (fine polishing step). The polishing step typically includes a stock polishing step and a final polishing step (last polishing step). Patent Documents 1 to 3 are exemplary technical references of a polishing composition mainly used in application of polishing a semiconductor substrate such as a silicon wafer.

[Citation List]

[Patent Literature]

[Patent Document 1] Japanese Patent No. 6185432
[Patent Document 2] Japanese Patent No. 6348927
[Patent Document 3] Japanese Patent No. 6232243

[Summary of Invention]

[Technical Problem]

A polishing composition for use has a polishing capability to efficiently polish an object to be polished. For example, polishing of a semiconductor substrate, such as a silicon wafer as described above, or other substrates can be leveraged by mechanical polishing action by an abrasive and chemical polishing action by a basic compound (alkaline etching), which provide higher removal ability. A polishing composition with high removal ability is preferred because it enables improvement in production efficiency, cost effectiveness, etc. In such polishing, use of silica particles as an abrasive allows efficiently providing a polished surface with a good quality.

In addition, a polishing composition used in polishing of the substrate, such as a polishing composition used in a final polishing step (particularly, a final polishing step of a semiconductor substrate such as a silicon wafer, or other substrates), is also required to have performance to provide a high-quality surface after polishing. Improvement in a surface quality of a polished surface is achieved by, e.g., a method of protecting a substrate from alkaline etching using a water-soluble polymer contained in a polishing composition. For example, Patent Documents 1 to 3 disclose a polishing composition containing silica particles, a basic compound, and a water-soluble polymer. However, in the conventional art, there has still been a room for reducing post-polishing defects (e.g., LPD-N (light point defect non-cleanable)) to provide an improved surface quality. Moreover, in general, there is a trade-off relationship between an improved quality of a polished surface and a polishing removal rate. Accordingly, it is practically beneficial to provide a polishing composition that can enhance a quality of a polished surface along with sustaining a polishing removal rate; as is particularly true in a final polishing step, for example.

The present invention thus has an object to provide a polishing composition that contains a water-soluble polymer and can offer a high-grade surface along with sustaining a polishing removal rate.

[Solution to Problem]

The description provides a polishing composition. The polishing composition contains silica particles (A) as an abrasive, a basic compound (B), a water-soluble polymer (C), and a chelating agent (D), wherein the water-soluble polymer (C) contains a modified polyvinyl alcohol-based polymer having an etching rate of 20 nm/h or less (C1).

The etching rate as described above is an indicator for evaluating performance of a water-soluble polymer (e.g., a modified polyvinyl alcohol-based polymer) to protect a surface of an object to be polished from alkaline corrosion (etching).

The etching rate is derived on the basis of the etching rate measurement as below.

[Etching Rate Measurement]

(1) Prepare a liquid agent for etching rate measurement LE containing 0.175% by weight of a modified polyvinyl alcohol-based polymer and 0.205% by weight of ammonia with the rest filled with water.
(2) Prepare a silicon single crystal substrate (having a rectangular shape with 6 cm in length, 3 cm in width, and 775 μm in thickness) by immersion in a cleaning liquid of $NH_4OH$ (29%) : $H_2O_2$ (31%) : deionized water (DIW) = 2:5.3:48 (volume ratio) at 25°C for 1 minute and then in an aqueous hydrogen fluoride (HF) solution (5%) at 25°C for 30 seconds, and measure a weight WO of the silicon single crystal substrate.
(3) Immerse the silicon single crystal substrate in the liquid agent LE at 25°C for 40 hours.
(4) Remove the silicon single crystal substrate from the liquid agent LE, and clean the silicon single crystal substrate with deionized water (DIW) at 25°C for 10 seconds.
(5) After cleaning, measure a weight W1 of the silicon single crystal substrate.
(6) Calculate an etching rate [nm/h] from a difference between the WO and the W1 and a specific gravity of the silicon single crystal substrate.

A low etching rate indicates high performance of a water-soluble polymer to protect a surface of an object to be polished from alkaline corrosion. A polishing composition having the aforementioned configuration employs a modified polyvinyl alcohol-based polymer with high protective performance against alkaline corrosion, thus provides protection of a surface of a silicon wafer, which is an object to be polished, and tends to reduce post-polishing defects (e.g., LPD-N). Moreover, use of a chelating agent in combination with such a modified polyvinyl alcohol-based polymer leads to a tendency to enable providing a high-quality surface with reduction in defects (e.g., LPD-N) after polishing, along with sustaining a polishing removal rate.

In some embodiments, the modified polyvinyl alcohol-based polymer (C1) is at least one kind selected from the group consisting of acetalized polyvinyl alcohol-based polymers, or polyvinyl alcohol-based polymers containing a repeating unit derived from alkyl vinyl ether. The particular modified polyvinyl alcohol-based polymer as described above tends to have high performance to protect a surface of an object to be polished from alkaline corrosion and facilitates improvement in a quality of a polished surface of an object to be polished.

In some embodiments, the content of the modified polyvinyl alcohol-based polymer (C1) is 0.5 parts by weight or more and 10 parts by weight or less relative to 100 parts by weight of the abrasive. Such composition can preferably offer an effect according to the art disclosed herein.

In some embodiments, the polishing composition further contains a water-soluble polymer (C2) having a chemical structure different from that of the modified polyvinyl alcohol-based polymer (C1) as the water-soluble polymer (C). Combination use of the modified polyvinyl alcohol-based polymer (C1) with the water-soluble polymer (C2) is expected to exert an effect such as improvement in a polishing removal rate, or reduction in defects. In some embodiments, a nitrogen atom-containing polymer can be used as the water-soluble polymer (C2). In the polishing composition disclosed herein, combination use of the modified polyvinyl alcohol-based polymer (C1) and a nitrogen atom-containing polymer tends to facilitate improvement in a polishing removal rate. Examples of such a nitrogen atom-containing polymer potentially preferably used include a polymer containing a cyclic amide having an N-(meth)acryloyl group as a monomer unit.

In some embodiments, one or two or more kinds selected from the group of aminocarboxylic acid-based chelating agents and organic phosphonic acid-based chelating agents can be used as the chelating agent (D). In the art disclosed herein, use of the particular chelating agent described above can provide the polishing composition with potential to better reduce post-polishing defects along with sustaining a polishing removal rate.

In some embodiments, the polishing composition further contains a surfactant (E). Such a configuration tends to better improve a quality of a polished surface. In a preferred embodiment, the surfactant (E) is a nonionic surfactant.

The polishing composition disclosed herein can be preferably used for polishing of a surface formed of a silicon material. Polishing a surface formed of a silicon material with use of the polishing composition allows efficient production of a high-quality surface formed of a silicon material.

The polishing composition disclosed herein may be a concentrate. The polishing composition disclosed herein may be produced, distributed, and stored in a concentrate form.

In some embodiments, a polishing method including polishing a surface formed of a silicon material with use of the polishing composition is provided. The polishing method can offer a high-grade surface along with sustaining a polishing removal rate.

[Description of Embodiments]

Preferred embodiments of the present invention will be described below. Matters that are other than those particularly mentioned herein but are necessary for implementation of the present invention can be recognized as matters to be designed by those skilled in the art based on conventional technologies in the art. The present invention can be implemented based on contents disclosed herein and common technical knowledge in the art.

<Abrasive>

The polishing composition disclosed herein contains silica particles as an abrasive. Silica particles as an abrasive function to mechanically polish a surface of an object to be polished. Inclusion of an abrasive in the polishing composition allows enhancing a polishing removal rate based on mechanical polishing action caused by presence of an abrasive. When the polishing composition can be used in polishing (e.g., final polishing) of an object to be polished having a surface formed of silicon, such as a silicon wafer as described later, it is particularly significant to employ silica particles as an abrasive.

Specific examples of the silica particles include colloidal silica, fumed silica, and precipitated silica. The silica particles can be used singly or in combination of two or more kinds thereof. Colloidal silica is particularly preferably used because it facilitates production of a polished surface with an excellent surface grade after polishing. Examples of colloidal silica to be potentially preferably employed include colloidal silica prepared from water glass (sodium silicate) as a raw material by ion-exchanging, and colloidal silica prepared from alkoxide (colloidal silica produced by a hydrolysis-condensation reaction of alkoxysilane). Colloidal silica can be used singly or in combination of two or more kinds thereof.

The absolute specific gravity of silica that forms the silica particles is preferably 1.5 or more, more preferably 1.6 or more, even more preferably 1.7 or more. The upper limit of the absolute specific gravity of silica is not particularly limited, and is typically 2.3 or less, e.g., 2.2 or less. As the absolute specific gravity of the silica particles, a measured value derived by liquid replacement using ethanol as a replacing liquid can be employed.

The average primary particle diameter of the abrasive (typically, silica particles) is not particularly limited, and in view of a polishing removal rate, etc., it is preferably 5 nm or more, more preferably 10 nm or more. In view of providing a higher effect of polishing (an effect such as reduction in haze or removal of a defect), the average primary particle diameter is preferably 15 nm or more, more preferably 20 nm or more (e.g., more than 20 nm). In view of preventing a scratch, etc., the average primary particle diameter of the abrasive is preferably 100 nm or less, more preferably 50 nm or less, even more preferably 45 nm or less. In view of producing a lower-haze surface with ease, the average primary particle diameter of the abrasive in some embodiments may be 43 nm or less, less than 40 nm, less than 38 nm, less than 35 nm, less than 32 nm, or less than 30 nm.

An average primary particle diameter, as used herein, refers to a particle diameter (BET particle diameter) calculated from a specific surface area measured by a BET method (BET value) by the formula: average primary particle diameter (nm) = 6000/(true density (g/cm$^3$) $\times$ BET value (m$^2$/g)). The specific surface area can be measured using e.g., a surface area measurement device with the product name of "Flow Sorb II 2300", manufactured by Micromeritics Instrument Corporation.

The average secondary particle diameter of the abrasive (typically, silica particles) is not particularly limited, and can be appropriately selected from, e.g., the range of about 15 nm to 300 nm. In view of improving a polishing removal rate, the average secondary particle diameter is preferably 30 nm or more, and more preferably 35 nm or more. In some embodiments, the average secondary particle diameter may be, e.g., 40 nm or more, 42 nm or more, or preferably 44 nm or more. The average secondary particle diameter may be 250 nm or less, preferably 200 nm or less, more preferably 150 nm or less. In some preferred embodiments, the average secondary particle diameter is 120 nm or less, more preferably 100 nm or less, even more preferably 70 nm or less, and may be e.g., 60 nm or less or 50 nm or less.

An average secondary particle diameter, as used herein, refers to a particle diameter (volume average particle diameter) measured by dynamic light scattering. The average secondary particle diameter of the abrasive can be measured by dynamic light scattering using e.g., the product named "NANOTRAC UPA-UT151" manufactured by Nikkiso Co., Ltd.

The shape (outer shape) of the silica particles may be globular or non-globular. Specific examples of the particles having non-globular forms include peanut-shaped (i.e., peanut shell-shaped) particles, cocoon-shaped particles, konpeito-shaped particles, and rugby ball-shaped particles. For example, the particles majorly including peanut-shaped or cocoon-shaped particles may be preferably employed.

Without particular limitation, the average value of major axis/minor axis ratios (average aspect ratio) of the silica particles is theoretically 1.0 or more, preferably 1.05 or more, even more preferably 1.1 or more, and may be 1.2 or more. Increase in the average aspect ratio can achieve a higher polishing removal rate. In view of reducing scratches, etc., the average aspect ratio of the silica particles is preferably 3.0 or less, more preferably 2.0 or less, even more preferably 1.5 or less, and may be 1.4 or less.

An exemplary specific procedure for acquiring the shape (outer shape) and the average aspect ratio of the silica particles can be as follows: with use of a scanning electron microscope (SEM), collecting a predetermined number (e.g., 200) of the silica particles each independently having a discriminable shape; drawing a minimum rectangle circumscribed to an image of each of the collected particles; then calculating, as a major axis/minor axis ratio (aspect ratio), a value by dividing the long side length (major axis value) by the short side length (minor axis value) for the rectangle drawn for the image of each of the particles; and deriving the average aspect ratio from an arithmetic average of the aspect ratios for the predetermined number of the particles.

The polishing composition disclosed herein may contain an abrasive other than silica particles (hereinafter also referred to as "non-silica abrasive"), as far as an effect of the present invention is not significantly inhibited. Examples of the non-silica abrasive include inorganic particles, organic particles, and organic-inorganic composite particles. Specific examples of the inorganic particles include oxide particles such as alumina particles, cerium oxide particles, chromium oxide particles, titanium dioxide particles, zirconium oxide particles, magnesium oxide particles, manganese dioxide particles, zinc oxide particles, and red iron oxide particles; nitride particles such as silicon nitride particles and boron nitride particles; carbide particles such as silicon carbide particles and boron carbide particles; diamond particles; and carbonate salts such as calcium carbonate and barium carbonate. Specific examples of the organic particles include polymethylmethacrylate (PMMA) particles, poly(meth)acrylic acid particles ((meth)acrylic acid in this context is intended to refer inclusively to acrylic acid and methacrylic acid), and polyacrylonitrile particles. Such an abrasive can be used singly or in combination of two or more kinds thereof.

The art disclosed herein can be preferably performed in an embodiment where substantially only silica particles are used as an abrasive. In such a view, the proportion of silica particles in the total amount of an abrasive is suitably 90% by weight or more, preferably 95% by weight or more, more preferably 98% by weight or more (e.g., 99 to 100% by weight).

<Basic Compound (B)>

The polishing composition disclosed herein contains a basic compound. As used herein, a basic compound refers to a compound having a function to be dissolved in water to rise the pH of an aqueous solution. Inclusion of a basic compound in the polishing composition provides chemical polishing action (alkaline etching), by which an object to be polished can be efficiently polished. Available examples of the basic compound include organic or inorganic nitrogen-containing basic compounds, phosphorus-containing basic compounds, hydroxides of alkali metals, hydroxides of alkaline earth metals, and various carbonate salts or hydrogen carbonate salts. Examples of the nitrogen-containing basic compounds include quaternary ammonium compounds, ammonia, amines (preferably, water-soluble amines). Examples of the phosphorus-containing basic compounds include quaternary phosphonium compounds. Such a basic compound can be used singly or in combination of two or more kinds thereof.

Specific examples of the hydroxides of alkali metals include potassium hydroxide and sodium hydroxide. Specific examples of the carbonate salts or hydrogen carbonate salts include ammonium hydrogen carbonate, ammonium carbonate, potassium hydrogen carbonate, potassium carbonate, sodium hydrogen carbonate, and sodium carbonate. Specific examples of the amines include, methylamine, dimethylamine, trimethylamine, ethylamine, diethylamine, triethylamine, ethylenediamine, monoethanolamine, N-(β-aminoethyl)ethanolamine, hexamethylenediamine, diethylenetriamine, triethylenetetramine, piperazine anhydride, piperazine hexahydrate, 1-(2-aminoethyl) piperazine, N-methylpiperazine, guanidine, and azoles such as imidazole and triazole. Specific examples of the quaternary phosphonium compounds include quaternary phosphonium hydroxides such as tetramethylphosphonium hydroxide and tetraethylphosphonium hydroxide.

As the quaternary ammonium compound, quaternary ammonium salts (typically, strong bases) such as tetraalkyl ammonium salts and hydroxyalkyl trialkyl ammonium salts can be used. An anion component in such quaternary ammonium salts may be, e.g., $OH^-$, $F^-$, $Cl^-$, $Br^-$, $I^-$, $ClO_4^-$, and $BH_4^-$. Examples of the quaternary ammonium compound include quaternary ammonium salts having $OH^-$ as an anion, i.e., quaternary ammonium hydroxides. Specific examples of the quaternary ammonium hydroxides include tetraalkyl ammonium hydroxides such as tetramethylammonium hydroxide, tetraethylammonium hydroxide, tetrapropylammonium hydroxide, tetrabutylammonium hydroxide, tetrapentylammonium hydroxide, and tetrahexylammonium hydroxide; hydroxyalkyl trialkylammonium hydroxides such as 2-hydroxyethyltrimethylammonium hydroxide (also referred to as choline).

Among these basic compounds, at least one kind of basic compound selected from e.g., alkali metal hydroxides, quaternary ammonium hydroxides, or ammonia can be preferably used. In particular, more preferred are tetraalkyl ammonium hydroxide (e.g., tetramethylammonium hydroxide) and ammonia, and particularly preferred is ammonia.

<Water-soluble Polymer (C)>

The polishing composition disclosed herein contains a water-soluble polymer. The water-soluble polymer may serve protection of a surface of an object to be polished, enhancement in wettability of a polished surface of the object to be

polished, etc. The polishing composition disclosed herein has a characteristic of containing a water-soluble polymer having relatively high protective performance (substrate protectivity) for a surface to be polished against alkaline etching, as the water-soluble polymer. When containing a water-soluble polymer with high substrate protectivity, the polishing composition tends to provide reduction in defects (e.g., LPD-N) on a polished surface.

(Modified Polyvinyl Alcohol-based Polymer (C1))

In the art disclosed herein, the polishing composition contains a modified polyvinyl alcohol-based polymer having an etching rate of 20 nm/h or less (hereinafter also referred to as "modified polyvinyl alcohol-based polymer (C1)"). Herein, the etching rate of a modified polyvinyl alcohol-based polymer can be derived based on predetermined etching rate measurement as follows. The same applies to the examples described later.

[Etching Rate Measurement]

(1) Prepare a liquid agent for etching rate measurement LE containing 0.175% by weight of a modified polyvinyl alcohol-based polymer and 0.205% by weight of ammonia with the rest filled with water.
(2) Prepare a silicon single crystal substrate (having a rectangular shape with 6 cm in length, 3 cm in width, and 775 μm in thickness) by immersion in a cleaning liquid of $NH_4OH$ (29%) : $H_2O_2$ (31%) : deionized water (DIW) = 2:5.3:48 (volume ratio) at 25°C for 1 minute and then in an aqueous hydrogen fluoride (HF) solution (5%) at 25°C for 30 seconds, and measure a weight WO.
(3) Immerse the silicon single crystal substrate in the liquid agent LE at room temperature for 40 hours.
(4) Remove the silicon single crystal substrate from the liquid agent LE, and clean the silicon single crystal substrate with deionized water (DIW) at 25°C for 10 seconds.
(5) After cleaning, measure a weight W1 of the silicon single crystal substrate.
(6) Calculate an etching rate [nm/h] from a difference between the WO and the W1 and a specific gravity of the silicon single crystal substrate.

An etching rate based on the predetermined etching rate measurement can be an indicator for evaluating performance of a water-soluble polymer to protect a surface of an object to be polished from alkaline corrosion under a condition of eliminating an effect of mechanical action by an abrasive, and depends on a characteristic of a water-soluble polymer. A lower etching rate tends to indicate higher performance to prevent an event in which a water-soluble polymer is absorbed onto a surface of an object to be polished and causes the surface to undergo chemical etching by a basic compound or the like, i.e., higher performance to protect a surface of an object to be polished.

The reason why use of the modified polyvinyl alcohol-based polymer (C1) reduces post-polishing defects is not particularly limitedly construed. In general, polyvinyl alcohol-based polymers are estimated to act on a substrate surface and thereby protect the substrate surface, thus contributing to improvement in a quality of a polished surface (particularly, reduction in haze, defects, and the like). Moreover, modified polyvinyl alcohol-based polymers are likely to have a lower etching rate (i.e., higher substrate protective performance) relative to unmodified polyvinyl alcohol-based polymers. Among modified polyvinyl alcohol-based polymers, particular use of a modified polyvinyl alcohol-based polymer having an etching rate of 20 nm/h or less is expected to provide higher performance to protect a surface of an object to be polished, and more improvement in a post-polishing effect to reduce defects.

In some embodiments, the etching rate of the modified polyvinyl alcohol-based polymer (C1) is more preferably 19 nm/h or less (e.g., 18 nm/h or less), even more preferably 17 nm/h or less. The lower limit of the etching rate of the modified polyvinyl alcohol-based polymer is not particularly limited. In view of improving a polishing removal rate by leveraging an etching effect by alkali, the etching rate of the modified polyvinyl alcohol-based polymer (C1) is usually, suitably 1 nm/h or more, preferably 2 nm/h or more, more preferably 3 nm/h or more (e.g., 4 nm/h or more). In view of improving a polishing removal rate, the etching rate of the modified polyvinyl alcohol-based polymer (C1) may be 5 nm/h or more, 7 nm/h or more, 10 nm/h or more, 12 nm/h or more, or 15 nm/h or more.

A polyvinyl alcohol-based polymer, as used herein, refers to a polymer containing a vinyl alcohol unit (hereinafter also referred to as "VA unit") as a repeating unit therein. In addition, a modified polyvinyl alcohol-based polymer refers to a polyvinyl alcohol-based polymer containing a repeating unit other than VA units (hereinafter also referred to as "non-VA unit) in addition to VA units as repeating units. The modified polyvinyl alcohol-based polymer may be a random copolymer, a block copolymer, an alternate copolymer, a graft copolymer, or the like containing a VA unit and a non-VA unit. The modified polyvinyl alcohol-based polymer may contain only one kind of non-VA unit, or two or more kinds of non-VA units.

The modified polyvinyl alcohol-based polymer may be a polymer containing a VA unit, and a non-VA unit having at least one structure selected from an oxyalkylene group, a carboxy group, a (di)carboxylic group, a (di)carboxylic ester

group, a phenyl group, a naphthyl group, a sulfo group, an amino group, a hydroxy group, an amide group, an imide group, a nitrile group, an ether group, an ester group, or salts thereof. Examples of a non-VA unit that may be contained in the modified polyvinyl alcohol-based polymer may include, but are not limited to, a repeating unit derived from an *N*-vinyl-type monomer, an *N*-(meth)acryloyl-type monomer, or the like as described later, a repeating unit derived from ethylene, a repeating unit derived from alkyl vinyl ether, a repeating unit derived from a vinyl ester of monocarboxylic acid having a carbon atom number of 3 or more, and a repeating unit derived from a (di)acetone compound. A preferred example of the *N*-vinyl-type monomer may be *N*-vinylpyrrolidone. A preferred example of the *N*-(meth)acryloyl-type monomer can be *N*-(meth)acryloyl morpholine. The alkyl vinyl ether may be vinyl ether having an alkyl group having a carbon atom number of 1 or more and 10 or less, such as propylvinyl ether, butyl vinyl ether, or 2-ethylhexylvinyl ether. The vinyl ester of monocarboxylic acid having a carbon atom number of 3 or more may be a vinyl ester of monocarboxylic acid having a carbon atom number of 3 or more and 7 or less, such as vinyl propionate, vinyl butylate, vinyl pentanoate, and vinyl hexanoate. Preferred examples of the (di)acetone compound include diacetone (meth)acrylamide and acetylacetone.

In some preferred embodiments, an acetalized polyvinyl alcohol-based polymer is used as the modified polyvinyl alcohol-based polymer. Examples of the acetalized polyvinyl alcohol-based polymer include a polymer where a part of VA units in the polyvinyl alcohol-based polymer are acetalized. A modified polyvinyl alcohol-based polymer (acetalized PVA (Ac-PVA)) derived by acetalizing a part of VA units in the polyvinyl alcohol-based polymer can be provided by reacting and acetalizing a part of hydroxy groups in the polyvinyl alcohol-based polymer with an aldehyde compound or a ketone compound. Typically, the acetalized polyvinyl alcohol-based polymer can be provided by an acetalization reaction of the polyvinyl alcohol-based polymer and an aldehyde compound. In some preferred embodiments, the carbon number of the aldehyde compound is 1 to 7, more preferably 2 to 7.

Examples of the aldehyde compound include formaldehyde; linear or branched alkyl aldehydes such as acetaldehyde, propionaldehyde, *n*-butylaldehyde, isobutylaldehyde, *t*-butylaldehyde, and hexylaldehyde; alicyclic or aromatic aldehydes such as cyclohexanecarbaldehyde, and benzaldehyde. These can be used singly or in combination of two or more kinds thereof. The aldehyde compound may also have one or more hydrogen atoms substituted with halogen or the like except for formaldehyde. In particular, in view of high solubility to water and ease of an acetalization reaction, preferred are linear or branched alkyl aldehydes, and particularly more preferred are acetaldehyde, *n*-propylaldehyde, *n*-butylaldehyde, and n-pentylaldehyde.

As the aldehyde compound, in addition to the aforementioned substances, an aldehyde compound having a carbon number of 8 or more, such as 2-ethylhexylaldehyde, nonyl aldehyde, or decyl aldehyde, may be used.

The acetalized polyvinyl alcohol-based polymer contains a VA unit of a structural segment represented by the following chemical formula: $-CH_2-CH(OH)-$, and an acetalized structure unit represented by the following general formula (1) (hereinafter also referred to as "VAC unit").

[Chem 1]

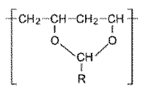

(1)

(in the formula (1), R is a hydrogen atom, or a linear or branched alkyl group, and the alkyl group may be substituted by a functional group.)

In some preferred embodiments, R in the formula (1) is a hydrogen atom or a linear or branched alkyl group having a carbon number of 1 to 6. Among these, R may be one kind or a combination of two or more kinds. In view of enhancing performance to reduce haze, R is preferably a linear or branched alkyl chain having a carbon number of 1 to 6.

In view of enhancing performance to reduce haze, the acetalization degree of the acetalized polyvinyl alcohol-based polymer can be 1% by mole or more, may be 5% by mole or more, preferably 10% by mole or more, more preferably 15% by mole or more, even more preferably 20% by mole or more, particularly preferably 25% by mole or more (e.g., 27% by mole or more). In view of enhancing hydrophilicity, the acetalization degree of the acetalized polyvinyl alcohol-based polymer is preferably less than 60% by mole, further 50% by mole or less, more preferably 40% by mole or less, particularly preferably 35% by mole or less (e.g., 33% by mole or less). As used herein, the term "acetalization degree" refers to a proportion of acetalized structure units (VAC units) in all repeating units forming an acetalized polyvinyl alcohol-based polymer.

In addition, as the modified polyvinyl alcohol-based polymer, a cation-modified polyvinyl alcohol in which a cationic group such as a quaternary ammonium structure is introduced may be used. Examples of the cation-modified polyvinyl alcohol include a substance in which a cationic group derived from a monomer having a cationic group such as a diallyl dialkyl ammonium salt or an N-(meth)acryloyl aminoalkyl-*N*,*N*,*N*-trialkyl ammonium salt. The modified polyvinyl alcohol-based polymer may contain a non-VA unit having a structure segment represented by the chemical formula: $-CH_2-CH(CR^1(OR^4)-CR^2(OR^5)-R^3)-$. Note that $R^1$ to $R^3$ each indicates independently a hydrogen atom or an organic

group, and that $R^4$ and $R^5$ each indicates independently a hydrogen atom or $R^6$-CO- (wherein $R^6$ indicates an alkyl group). For example, when at least one of $R^1$ to $R^3$ in the chemical formula is an organic group, the organic group may be a linear or branched alkyl group having a carbon number of 1 or more and 8 or less, etc. $R^6$ in the chemical formula may be a linear or branched alkyl group having a number of 1 or more and 8 or less.

In some embodiments, as the modified polyvinyl alcohol-based polymer, a modified polyvinyl alcohol-based polymer having a 1,2-diol structure in a side chain is used. Examples of the modified polyvinyl alcohol-based polymer include a polymer with a non-VA unit containing hydrogen atoms as the $R^1$ to $R^5$ (butenediol-vinyl alcohol copolymer (BVOH)).

The proportion of the amount by mole of VA units in the amount by mole in all repeating units forming the modified polyvinyl alcohol-based polymer may be, e.g., 5% or more, 10% or more, 20% or more, or 30% or more. Without particular limitation, in some embodiments, the proportion of the amount by mole of the VA unit may be 50% or more, 65% or more, 75% or more, or 80% or more. In some other embodiments, the proportion of the amount by mole of VA units in all repeating units forming the modified polyvinyl alcohol-based polymer may be, e.g., 95% or less, 90% or less, 80% or less, or 70% or less.

The content (content on a weight basis) of VA units in the modified polyvinyl alcohol-based polymer may be, e.g., 5% by weight or more, 10% by weight or more, 20% by weight or more, or 30% by weight or more. Without particular limitation, in some embodiments, the content of the VA units may be 50% by weight or more (e.g., more than 50% by weight), 70% by weight or more, or 80% by weight or more. In some other embodiments, the content of VA units in the modified polyvinyl alcohol-based polymer may be, e.g., 95% by weight or less, 90% by weight or less, 80% by weight or less, or 70% by weight or less.

The modified polyvinyl alcohol-based polymer may contain a plurality of polymer chains having various contents of VA units within the same molecule. As used herein, a polymer chain refers to a portion (segment) forming a part of a single molecule polymer. For example, the modified polyvinyl alcohol-based polymer may contain Polymer chain A, where the content of VA units is more than 50% by weight, and Polymer chain B, where the content of VA units is less than 50% by weight (i.e., the content of non-VA units is more than 50% by weight), within the same molecule.

Polymer chain A may contain only VA units as repeating units, or a non-VA unit in addition to VA units. The content of VA units in Polymer chain A may be 60% by weight or more, 70% by weight or more, 80% by weight or more, or 90% by weight or more. In some embodiments, the content of VA units in Polymer chain A may be 95% by weight or more, or 98% by weight or more. Substantially 100% by weight of repeating units forming Polymer chain A may be VA units.

Polymer chain B may contain only non-VA units as a repeating unit, or a VA unit in addition to non-VA units. The content of non-VA units in Polymer chain B may be 60% by weight or more, 70% by weight or more, 80% by weight or more, or 90% by weight or more. In some embodiments, the content of non-VA units in Polymer chain B may be 95% by weight or more, or 98% by weight or more. Substantially 100% by weight of repeating units forming Polymer chain B may be non-VA units.

Examples of a modified polyvinyl alcohol-based polymer containing Polymer chain A and Polymer chain B within the same molecule include a block copolymer and a graft copolymer containing these polymer chains. The graft copolymer may be a graft copolymer having a structure of Polymer chain A (main chain) grafted with Polymer chain B (side chain), or a graft copolymer having a structure of Polymer chain B (main chain) grafted with Polymer chain A (side chain). In some embodiments, a modified polyvinyl alcohol-based polymer having a structure of Polymer chain A grafted with Polymer chain B can be used.

Examples of Polymer chain B include a polymer chain containing a repeating unit derived from an N-vinyl-type monomer as a main repeating unit; a polymer chain containing a repeating unit derived from an N-(meth)acryloyl-type monomer as a main repeating unit; a polymer chain containing a repeating unit derived from dicarboxylic vinyl such as fumaric acid, maleic acid, or maleic anhydride as a main repeating unit; a polymer chain containing a repeating unit derived from an aromatic vinyl monomer such as styrene or vinylnaphthalene as a main repeating unit; and a polymer chain containing an oxyalkylene unit as a main repeating unit. Note that a main repeating unit herein refers to a repeating unit occupying more than 50% by weight unless otherwise stated.

A preferred example of Polymer chain B is a polymer chain containing an N-vinyl-type monomer as a main repeating unit, i.e., an N-vinyl-based polymer chain. The content of repeating units derived from *N*-vinyl-type monomers in an *N*-vinyl-based polymer chain is typically more than 50% by weight, and may be 70% by weight or more, 85% by weight or more, or 95% by weight or more. Substantially all of Polymer chain B may be formed of repeating units derived from *N*-vinyl-type monomers.

Herein, examples of the *N*-vinyl-type monomer include a monomer having a nitrogen-containing heterocycle (e.g., lactam ring), and *N*-vinyl chain amide (or *N*-vinyl acyclic amide). Specific examples of the *N*-vinyl lactam-type monomer include *N*-vinylpyrrolidone, *N*-vinylpiperidone, *N*-vinylmorpholinone, *N*-vinylcaprolactam, *N*-vinyl-1,3-oxazine-2-one, and *N*-vinyl-3,5-morpholinedione. Specific examples of the *N*-vinyl chain amide include *N*-vinyl acetoamide, *N-vinyl* propionamide, and *N*-vinyl butyramide. Polymer chain B may be, e.g., an *N*-vinyl-based polymer chain containing *N*-vinylpyrrolidone units occupying more than 50% by weight (e.g., 70% by weight or more, or 85% by weight or more, or

95% by weight or more) of repeating units. Substantially all of repeating units forming Polymer chain B may be *N*-vinylpyrrolidone units.

Other examples of Polymer chain B include a polymer chain containing a repeating unit derived from an *N*-(meth)acryloyl-type monomer as a main repeating unit, i.e., an *N*-(meth)acryloyl-based polymer chain. The content of repeating units derived from *N*-(meth)acryloyl-type monomers in an *N*-(meth)acryloyl-based polymer chain is typically more than 50% by weight, and may be 70% by weight or more, 85% by weight or more, or 95% by weight or more. Substantially all of Polymer chain B may be formed of repeating units derived from *N*-(meth)acryloyl-type monomers.

Herein, examples of the *N*-(meth)acryloyl-type monomer include a chain amide (or an acyclic amide) having an *N*-(meth)acryloyl group, and a cyclic amide having an *N*-(meth)acryloyl group. Examples of the chain amide having an *N*-(meth)acryloyl group include (meth)acrylamide; *N*-alkyl (meth)acrylamides such as *N*-methyl (meth)acrylamide, *N*-ethyl (meth)acrylamide, *N*-propyl (meth)acrylamide, *N*-isopropyl (meth)acrylamide, and *N*-*n*-butyl (meth)acrylamide; and *N,N*-dialkyl (meth)acrylamide such as *N,N*-dimethyl (meth)acrylamide, *N*,*N*-diethyl (meth)acrylamide, *N,N*-dipropyl (meth)acrylamide, *N*,*N*-diisopropyl (meth)acrylamide, and *N,N*-di(*n*-butyl) (meth)acrylamide. Examples of the cyclic amide having an *N*-(meth)acryloyl group include *N*-(meth)acryloyl morpholine and *N*-(meth)acryloyl pyrrolidine.

Other examples of Polymer chain B include a polymer chain containing an oxyalkylene unit as a main repeating unit, i.e., an oxyalkylene-based polymer chain. The content of oxyalkylene units in the oxyalkylene-based polymer chain is typically more than 50% by weight, and may be 70% by weight or more, 85% by weight or more, or 95% by weight or more. Substantially all of repeating units in Polymer chain B may be oxyalkylene units.

Examples of the oxyalkylene unit include an oxyethylene unit, an oxypropylene unit, and an oxybutylene unit. Each of these oxyalkylene units may be a repeating unit derived from a corresponding alkylene oxide. Oxyalkylene units in the oxyalkylene-based polymer chain may be occupied by one kind or two or more kinds. For example, the oxyalkylene-based polymer chain may contain oxyethylene units and oxypropylene units in combination. In an oxyalkylene-based polymer chain containing two or more kinds of oxyalkylene units, each of these oxyalkylene units may be a random copolymer, a block copolymer, an alternate copolymer, a graft copolymer, or the like of corresponding alkylene oxides.

Further examples of Polymer chain B include a polymer chain containing a repeating unit derived from alkyl vinyl ether (e.g., vinyl ether with an alkyl group having a carbon atom number of 1 or more and 10 or less), a polymer chain containing a repeating unit derived from monocarboxylic vinyl ester (e.g., vinyl ester of monocarboxylic acid having a carbon atom number of 3 or more), and a polymer chain introducing a cationic group (e.g., a cationic group having a quaternary ammonium structure).

In some embodiments, the saponification degree of a modified polyvinyl alcohol-based polymer is 50% by mole or more, preferably 65% by mole or more, more preferably 70% by mole or more, e.g., 75 % by mole or more.

In the art disclosed herein, the polishing composition contains a modified polyvinyl alcohol-based polymer having an etching rate of 20 nm/h or less (modified polyvinyl alcohol-based polymer (C1)), among the modified polyvinyl alcohol-based polymers described above. The etching rate of a water-soluble polymer can be adjusted by controlling the structure of a constituent unit (e.g., the structure of a non-VA unit in the modified polyvinyl alcohol-based polymer), the proportion of constituents (e.g., the proportion of non-VA units in the modified polyvinyl alcohol-based polymer), the molecular weight, or the like of the water-soluble polymer. Examples of the modified polyvinyl alcohol-based polymer having an etching rate of 20 nm/h or less include, but are not limited to, acetalized polyvinyl alcohol-based polymers, and polyvinyl alcohol-based polymers containing a repeating unit derived from alkyl vinyl ether. The modified polyvinyl alcohol-based polymer (C1) can be used singly or in combination of two or more kinds thereof.

In some embodiments, for example, the weight-average molecular weight (Mw) of the modified polyvinyl alcohol-based polymer (C1) can be $100 \times 10^4$ or less, suitably $60 \times 10^4$ or less. In view of concentration efficiency and the like, the Mw may be $30 \times 10^4$ or less, preferably $20 \times 10^4$ or less, e.g., $10 \times 10^4$ or less, $8 \times 10^4$ or less, $5 \times 10^4$ or less, or $3 \times 10^4$ or less. When the modified polyvinyl alcohol-based polymer (C1) has a smaller Mw, the modified polyvinyl alcohol-based polymer (C1) tends to have improved dispersion stability. Additionally, in view of preferably protecting a polished surface and maintaining or improving a surface quality, the Mw may be e.g., $0.2 \times 10^4$ or more, and is usually preferably $0.3 \times 10^4$ or more. Increase in the Mw of the modified polyvinyl alcohol-based polymer (C1) leads to a tendency to provide higher effects to protect an object to be polished and increase wettability. In such a view, the Mw in some embodiments is suitably $0.5 \times 10^4$ or more, preferably $0.8 \times 10^4$ or more.

As the Mw of a water-soluble polymer, a molecular weight calculated from a value based on aqueous gel permeation chromatography (GPC) (aqueous phase, on polyethylene oxide conversion basis) can be employed. The same applies to the MWs of the modified polyvinyl alcohol-based polymer (C1) and the water-soluble polymer described later (C2). As a GPC measurement apparatus, the machine named "HLC-8320GPC" manufactured by Tosoh Corporation can be used. Measurement can be performed in accordance with, e.g., the following conditions. The same method is also employed to the examples described later.

[GPC Measurement Conditions]

Sample concentration: 0.1% by weight
Column: TSKgel $GMPW_{XL}$
Detector: differential refractometer
Elution liquid: 100 mM sodium nitrate aqueous solution
Flow rate: 1 mL/min
Measurement temperature: 40°C
Sample injection volume: 200 μL

Without particular limitation, in some embodiments, the content of the modified polyvinyl alcohol-based polymer (C1) relative to 100 parts by weight of an abrasive (typically, silica particles) in the polishing composition can be, e.g., 0.01 parts by weight or more, and in view of reducing defects, the content is suitably 0.1 parts by weight or more, preferably 0.5 parts by weight or more, more preferably 1 part by weight or more, and may be 1.5 parts by weight or more, 2 parts by weight or more, 3 parts by weight or more, or 3.5 parts by weight or more. The content of the modified polyvinyl alcohol-based polymer (C1) relative to 100 parts by weight of an abrasive may also be e.g., 50 parts by weight or less, or 30 parts by weight or less. In view of dispersion stability of the polishing composition, the content of the modified polyvinyl alcohol-based polymer (C1) relative to 100 parts by weight of an abrasive in some embodiments is suitably 15 parts by weight or less, preferably 10 parts by weight or less, more preferably 5 parts by weight or less, and may be 3 parts by weight or less, 2.5 parts by weight or less, or 2 parts by weight or less. Appropriate setting of usage of the modified polyvinyl alcohol-based polymer (C1) from the aforementioned range can provide a high surface quality after polishing.

(Water-soluble Polymer (C2))

The polishing composition disclosed herein may contain, in addition to the modified polyvinyl alcohol-based polymer (C1), a second water-soluble polymer having a chemical structure different from that of the modified polyvinyl alcohol-based polymer (C1) (hereinafter also simply referred to as "water-soluble polymer (C2)"). Use of the water-soluble polymer (C2) with the modified polyvinyl alcohol-based polymer (C1) is expected to exert an effect such as enhancement in a polishing removal rate, or improvement in a quality of a polished surface. The water-soluble polymer (C2) is not particularly limited and can be used from a variety of polymers. The water-soluble polymer (C2) can be used singly or in combination of two or more kinds thereof.

Examples of the water-soluble polymer (C2) include compounds containing a hydroxyl group, a carboxy group, a acyloxy group, a sulfo group, an amide structure, an imido structure, a quaternary ammonium structure, a heterocyclic structure, a vinyl structure, etc. in a molecule. Available examples of the water-soluble polymer (C2) include cellulose derivatives, starch derivatives, oxyalkylene unit-containing polymers, polyvinyl alcohol-based polymers (except for the modified polyvinyl alcohol-based polymer (C1)), nitrogen atom-containing polymers, and (meth)acrylic acid-containing polymers. An available embodiment of the nitrogen atom-containing polymers may be an *N*-vinyl type polymer, an *N*-(meth)acryloyl type polymer, or the like. The water-soluble polymer (C2) may be a naturally-occurring polymer or a synthetic polymer.

In some embodiments, a naturally-occurring polymer is used as the water-soluble polymer (C2). Examples of the naturally-occurring polymer include cellulose derivatives and starch derivatives.

In some embodiments, a cellulose derivative is used as the water-soluble polymer (C2). As used herein, the cellulose derivative is a polymer that contains a β-glucose unit as a main repeating unit. Specific examples of the cellulose derivative include hydroxyethyl cellulose (HEC), hydroxypropyl cellulose, hydroxyethylmethyl cellulose, hydroxypropylmethyl cellulose, methylcellulose, ethylcellulose, ethylhydroxyethyl cellulose, and carboxy methylcellulose. In particular, HEC is preferred.

In some other embodiments, a starch derivative is used as the water-soluble polymer (C2). The starch derivative is a polymer containing an α-glucose unit as a main repeating unit, and examples thereof include pregelatinized starch, pullulan, carboxymethyl starch, and cyclodextrin.

In some other preferred embodiments, a synthetic polymer is used as the water-soluble polymer (C2). An effect to improve a surface grade disclosed herein is preferably exerted in an embodiment where a synthetic polymer is used as the water-soluble polymer (C2).

In some embodiments, an oxyalkylene unit-containing polymer is used as the water-soluble polymer (C2). Examples of the oxyalkylene unit-containing polymer include polyethylene oxide (PEO), a block copolymer of ethylene oxide (EO) and propylene oxide (PO) or butylene oxide (BO), and a random copolymer of EO and PO or BO. In particular, preferred are a block copolymer of EO and PO or a random copolymer of EO and PO. The block copolymer of EO and PO

may be a diblock copolymer or a triblock copolymer containing a PEO block and a polypropylene oxide (PPO) block, or the like. Examples of the triblock copolymer include PEO-PPO-PEO type triblock copolymers and PPO-PEO-PPO type triblock copolymers. Usually, more preferred are PEO-PPO-PEO type triblock copolymers.

A copolymer, as used herein, is intended to inclusively refer to various copolymers such as random copolymers, alternate copolymers, block copolymers, and graft copolymers, unless otherwise stated.

In a block copolymer or a random copolymer of EO and PO, the molar ratio (EO/PO) of EO and PO forming the copolymer is preferably more than 1, more preferably 2 or more, even more preferably 3 or more (e.g., 5 or more) in view of solubility in water, cleanability, etc.

In some embodiments, a polyvinyl alcohol-based polymer (except for the modified polyvinyl alcohol-based polymer (C1)) can be used as the water-soluble polymer (C2). Examples of such a polyvinyl alcohol-based polymer include unmodified polyvinyl alcohol (unmodified PVA) containing only VA units as a repeating unit. The saponification degree of the unmodified PVA may be, e.g., 60% or more, and in view of water solubility, it may be 70% or more, 80% or more, or 90% or more. In some embodiments, the saponifying degree of the unmodified PVA may be 98% or more (completely saponified).

In some embodiments, an *N*-vinyl-type polymer may be used as the water-soluble polymer (C2). Examples of the *N*-vinyl-type polymer include a polymer containing a repeating unit derived from a monomer having a nitrogen-containing heterocycle (e.g., lactam ring). Examples of such a polymer include homopolymers and copolymers of *N*-vinyllactam-type monomers (e.g., a copolymer containing *N*-vinyllactam-type monomers with a copolymerization ratio of more than 50% by weight), and homopolymers and copolymers of *N*-vinyl chain amide (e.g., a copolymer containing *N*-vinyl chain amide with a copolymerization ratio of more than 50% by weight).

Specific examples of the *N*-vinyllactam-type monomer (i.e., a compound having a lactam structure and an *N*-vinyl group within one molecule) include *N*-vinylpyrrolidone (VP), *N*-vinylpiperidone, *N*-vinylmorpholinone, *N*-vinylcaprolactam (VC), *N*-vinyl-1,3-oxazine-2-one, and *N*-vinyl-3,5-morpholinedione. Specific examples of a polymer containing the *N*-vinyllactam-type monomer unit include polyvinyl pyrrolidone; polyvinyl caprolactam; a random copolymer of VP and VC; a random copolymer of one or both of VP and VC with another vinyl monomer (e.g., an acrylic monomer and a vinyl ester-based monomer); and a block copolymer, an alternate copolymer, a graft copolymer, and the like containing a polymer chain containing one or both of VP and VC.

Specific examples of the *N*-vinyl chain amide include *N*-vinylacetoamide, *N*-vinyl-propionamide, and *N*-vinyl butyramide.

In some other embodiments, an *N*-(meth)acryloyl-type polymer may be used as the water-soluble polymer (C2). Examples of the *N*-(meth)acryloyl-type polymer include homopolymers and copolymers of *N*-(meth)acryloyl-type monomers (typically, a copolymer containing *N*-(meth)acryloyl-type monomers with a copolymerization ratio of more than 50% by weight). Examples of the *N*-(meth)acryloyl-type monomer include a chain amide having an *N*-(meth)acryloyl group, and a cyclic amide having an N-(meth)acryloyl group. As used herein, (meth)acryloyl-type is intended to inclusively refer to acryloyl-types and methacryloyl-types. As used herein, (meth)acryloyl group is intended to inclusively refer to acryloyl groups and methacryloyl groups.

Examples of the chain amide having an N-(meth)acryloyl group include (meth)acrylamides; *N*-alkyl (meth)acrylamides such as *N*-methyl (meth)acrylamide, *N*-ethyl (meth)acrylamide, *N*-propyl (meth)acrylamide, *N*-isopropyl (meth)acrylamide, and *N*-n-butyl (meth)acrylamide; and *N,N*-dialkyl (meth)acrylamides such as *N*,*N*-dimethyl (meth)acrylamide, *N,N*-diethyl (meth)acrylamide, *N,N*-dipropyl (meth)acrylamide, *N*,*N*-diisopropyl (meth)acrylamide, and *N,N*-di(*n*-butyl) (meth)acrylamide. Other examples thereof include *N*-hydroxyethylacrylamide (HEAA). Examples of a polymer containing the chain amide having an *N*-(meth)acryloyl group as a monomer unit include a homopolymer of *N*-isopropylacrylamide and a copolymer of *N*-isopropylacrylamide (e.g., a copolymer containing *N*-isopropylacrylamide with a copolymerization ratio of more than 50% by weight). As used herein, (meth)acrylamide is intended to inclusively refer to acrylamide and methacrylamide.

Examples of the cyclic amide having an *N*-(meth)acryloyl group include *N*-acryloylmorpholine, *N*-acryloylthiomorpholine, *N*-acryloylpiperidine, *N*-acryloylpyrrolidine, *N*-methacryloylmorpholine, *N*-methacryloylpiperidine, and *N*-methacryloylpyrrolidine. Examples of a polymer containing the cyclic amide having an *N*-(meth)acryloyl group as a monomer unit include an acryloyl morpholine-based polymer (PACMO). Typical examples of the acryloyl morpholine-based polymer include a homopolymer of *N*-acryloylmorpholine (ACMO) and a copolymer of ACMO (e.g., a copolymer containing ACMO with a copolymerization ratio of more than 50% by weight). In the acryloyl morpholine-based polymer, the proportion of the amount by mole of ACMO units in the amount by mole of all repeating units is usually 50% or more, and suitably 80% or more (e.g., 90% or more, typically 95% or more). All repeating units in the water-soluble polymer (C2) may be substantially occupied by ACMO units.

In some embodiments, a carboxylic acid-based polymer is used as the water-soluble polymer (C2). Examples of the carboxylic acid-based polymer include maleic acid unit-containing polymers and (meth)acrylic acid unit-containing polymers. Examples of the maleic acid unit-containing polymers include styrene-maleic acid copolymer or salts thereof, styrene-maleic anhydride copolymer, styrenesulfonic acid-maleic acid copolymer or salts thereof, styrenesulfonic acid

salt-maleic acid copolymer, and maleic acid-vinyl acetate copolymer. Examples of the (meth)acrylic acid unit-containing polymers include polyacrylic acid or salts thereof, styrene-acrylic acid copolymer or salts thereof, styrenesulfonic acid-acrylic acid copolymer or salts thereof, styrenesulfonic acid salt-acrylic acid copolymer, acrylic acid-vinyl acetate copolymer, and acrylic acid/sulfonic acid-based monomer copolymer. As used herein, (meth)acrylic acid is intended to inclusively refer to acrylic acid and methacrylic acid.

When the water-soluble polymer (C2) is a polymer containing, as a monomer unit, a chain amide having an N-(meth)acryloyl group, the Mw of the water-soluble polymer (C2) can be, e.g., $100 \times 10^4$ or less, and is suitably $50 \times 10^4$ or less. In view of concentration efficiency and the like, the Mw may be $30 \times 10^4$ or less, $10 \times 10^4$ or less, $8 \times 10^4$ or less, or $6 \times 10^4$ or less. In view of improving a surface quality, the Mw may be, e.g., $1 \times 10^4$ or more, $2 \times 10^4$ or more, or $3 \times 10^4$ or more (e.g., $4 \times 10^4$ or more). Use of the water-soluble polymer (C2) with a high Mw is likely to result in a high surface quality.

When the water-soluble polymer (C2) is a polymer containing, as a monomer unit, a cyclic amide having an *N*-(meth)acryloyl group, the Mw of the water-soluble polymer (C2) can be, e.g., $100 \times 10^4$ or less, and is suitably $70 \times 10^4$ or less. In view of concentration efficiency and the like, the Mw may be $60 \times 10^4$ or less, $50 \times 10^4$ or less, $35 \times 10^4$ or less, less than $35 \times 10^4$, $30 \times 10^4$ or less, or $20 \times 10^4$ or less. In view of improving a surface quality, the Mw may be, e.g., $1.0 \times 10^4$ or more, $5 \times 10^4$ or more, $10 \times 10^4$ or more, $15 \times 10^4$ or more, $20 \times 10^4$ or more, or $25 \times 10^4$ or more (e.g., more than $25 \times 10^4$). Use of the water-soluble polymer (C2) with a high Mw is likely to result in a high surface quality.

When the water-soluble polymer (C2) is a polymer containing a (meth)acrylic acid unit, the Mw of the water-soluble polymer (C2) can be, e.g., $800 \times 10^4$ or less, and is suitably $500 \times 10^4$ or less. In view of concentration efficiency and the like, the Mw may be $300 \times 10^4$ or less, preferably $200 \times 10^4$ or less, e.g., $175 \times 10^4$ or less, $150 \times 10^4$ or less, or $140 \times 10^4$ or less. In view of preferably protecting a polished surface to maintain and improve a surface quality, the Mw may be, e.g., $20 \times 10^4$ or more, $50 \times 10^4$ or more, or $100 \times 10^4$ or more (e.g., $130 \times 10^4$ or more). Use of the water-soluble polymer (C2) with a high Mw is likely to result in a high surface quality.

When the water-soluble polymer (C2) is a polymer containing an oxyalkylene unit, the Mw of the water-soluble polymer (C2) can be $10 \times 10^4$ or less, and may be $5 \times 10^4$ or less, $3 \times 10^4$ or less, or $2 \times 10^4$ or less. The Mw can be $5 \times 10^3$ or more, and may be $1 \times 10^4$ or more, $1.2 \times 10^4$ or more, or $1.5 \times 10^4$ or more.

Without particular limitation, in some embodiments, a substance having a Mw higher than the Mw of the modified polyvinyl alcohol-based polymer (C1) can be preferably used as the water-soluble polymer (C2). For example, the ratio of the Mw of the water-soluble polymer (C2) to the Mw of the modified polyvinyl alcohol-based polymer (C1) is preferably more than 1, and may be 1.1 or more, 1.3 or more, 1.5 or more, 1.8 or more, 2 or more, 3 or more, 5 or more, 10 or more, 15 or more, 20 or more, 30 or more, or 50 or more. For example, the ratio of the Mw of the water-soluble polymer (C2) to the Mw of the modified polyvinyl alcohol-based polymer (C1) may be 300 or less, 250 or less, 200 or less, 150 or less, or 100 or less. Use of the Mws of two kinds of water-soluble polymers having such relative Mws can preferably achieve a high surface quality after polishing.

Without particular limitation, in some embodiments, the content of the water-soluble polymer (C2) in the polishing composition relative to 100 parts by weight of an abrasive (typically silica particles) can be, e.g., 0.01 parts by weight or more, and in view of reduction in haze, etc., it is suitably 0.1 parts by weight or more, preferably 0.5 parts by weight or more, more preferably 1 part by weight or more, and may be 2 parts by weight or more. The content of the water-soluble polymer (C2) relative to 100 parts by weight of an abrasive may also be, e.g., 50 parts by weight or less, or 30 parts by weight or less. In view of dispersion stability of the polishing composition, etc., the content of the water-soluble polymer (C2) relative to 100 parts by weight of an abrasive in some embodiments is suitably 15 parts by weight or less, preferably 10 parts by weight or less, more preferably 5 parts by weight or less, and may be, e.g., 3.5 parts by weight or less. Appropriate setting of usage of the water-soluble polymer (C2) from the aforementioned range can result in a high surface quality.

Without particular limitation, in some embodiments, the total content of water-soluble polymers in the polishing composition relative to 100 parts by weight of an abrasive (typically silica particles) can be, e.g., 0.01 parts by weight or more, and in view of improving a surface quality, etc., it is suitably 0.1 parts by weight or more, preferably 0.5 parts by weight or more, more preferably 1 part by weight or more, even more preferably 2 parts by weight or more, particularly preferably 4 parts by weight or more, and may be 6 parts by weight or more. The total content of the water-soluble polymers relative to 100 parts by weight of an abrasive may also be, e.g., 50 parts by weight or less, or 30 parts by weight or less. In view of dispersion stability of the polishing composition, etc., the total content of the water-soluble polymers relative to 100 parts by weight of an abrasive in some embodiments is suitably 15 parts by weight or less, preferably 12 parts by weight or less, and may be 10 parts by weight or less (e.g., less than 10 parts by weight).

Without particular limitation, in some embodiments, the ratio (W2/W1) of the content W2 of the water-soluble polymer (C2) to the contentW1 of the modified polyvinyl alcohol-based polymer (C1) is, e.g., 0.01 or more, suitably 0.1 or more, and preferably 0.2 or more, and may be 0.4 or more, 0.6 or more, or 0.8 or more, on a weight basis. The upper limit of the ratio (W2/W1) is, e.g., 10 or less, suitably 5 or less, preferably 3 or less, more preferably less than 2, and may be 1 or less (less than 1), on a weight basis. Appropriate settings of the ratio (W2/W1) within the aforementioned range can leads to preferable exertion of an effect of the art disclosed herein.

<Chelating agent (D)>

The polishing composition disclosed herein has a characteristic of containing a chelating agent. In general, a chelating agent prevents metallic contamination by capturing metallic impurities in the polishing composition and forming a complex, thus contributing to reduction in defects derived from metallic contamination. Use of such a chelating agent with silica particles as an abrasive, and the modified polyvinyl alcohol-based polymer (C1), which has high surface protectivity of an object to be polished, tends to provide improvement in a polishing removal rate in addition to reduction in defects on a polished surface. In the art disclosed herein, the reason for improving a polishing removal rate by addition of a chelating agent is, without particular limitation, considered to be that the chelating agent functions to attract silica particles close to a surface of an object to be polished and thereby improves a frequency of silica particles to act on a polished surface, thus contributing to improvement in a polishing removal rate.

Examples of the chelating agent include aminocarboxylic acid-based chelating agents and organic phosphonic acid-based chelating agents. Specific examples of the aminocarboxylic acid-based chelating agents include alanine, glycine, ethylenediamine tetraacetic acid, sodium ethylenediamine tetraacetate, nitorilotriacetic acid, sodium nitrilotriacetate, ammonium nitrilotriacetate, hydroxyethylethylenediamine triacetic acid, sodium hydroxyethylethylenediamine triacetate, diethylenetriamine pentaacetic acid, sodium diethylenetriamine pentaacetate, triethylenetetramine hexaacetic acid, sodium triethylenetetramine hexaacetate, and *trans*-1,2-cyclohexanediamine tetraacetic acid. Specific examples of the organic phosphonic acid-based chelating agents include 2-aminoethyl phosphonic acid, 1-hydroxyethylidene-1,1-diphosphonic acid, aminotri(methylene phosphonic acid), ethylenediamine tetrakis(methylene phosphonic acid), diethylenetriamine penta(methylene phosphonic acid), ethane-1,1-diphosphonic acid, ethane-1,1,2-triphosphonic acid, ethane-1-hydroxy-1,1-diphosphonic acid, ethane-1-hydroxy-1,1,2-triphosphonic acid, ethane-1,2-dicarboxylic-1,2-diphosphonic acid, methane hydroxy phosphonic acid, 2-phosphonobuthane-1,2-dicarboxylic acid, phosphonobuthane tricarboxylic acid (PBTC), nitrotris(methylene phosphoric acid) (NTMP), and $\alpha$-methylphosphonosuccinic acid. Among these chelating agents, preferred are ethylenediamine tetraacetic acid, diethylenetriamine pentaacetic acid, triethylenetetramine hexaacetic acid, ethylenediamine tetrakis(methylene phosphonic acid), diethylenetriamine penta(methylene phosphonic acid), and *trans*-1,2-cyclohexanediamine tetraacetic acid, and more preferred are ethylenediamine tetrakis(methylene phosphonic acid), triethylenetetramine hexaacetic acid, and trans-1,2-cyclohexanediamine tetraacetic acid. The chelating agent can be used singly or in combination of two or more kinds thereof.

Without particular limitation, the content of the chelating agent relative to 100 parts by weight of an abrasive (typically, silica particles) in some embodiments can be e.g., 0.01 parts by weight or more, and in view of reducing defects due to metallic contamination, the content is suitably 0.1 parts by weight or more, preferably 0.5 parts by weight or more, and more preferably 1 part by weight or more, and may be 2 part by weight or more. The content of the chelating agent relative to 100 parts by weight of an abrasive may also be, e.g., 20 parts by weight or less, or 10 parts by weight or less. In view of dispersion stability of the polishing composition, etc., the content of a chelating agent relative to 100 parts by weight of an abrasive in some embodiments is suitably 7 parts by weight or less, preferably 5 parts by weight or less, and more preferably 3 parts by weight or less, and may be, e.g., 2.5 parts by weight or less. Appropriate setting of usage of the chelating agent from the aforementioned range can provide a high surface quality.

<Surfactant (E)>

In some embodiments, the polishing composition preferably contains at least one kind of surfactant. Inclusion of a surfactant in the polishing composition can reduce haze on a polished surface. According to the art disclosed herein, composition containing the above-described combination of water-soluble polymers and a surfactant enables more improvement in a quality of a polished surface. As the surfactant, any of anionic, cationic, nonionic, or amphoteric substance is available. Usually, an anionic or nonionic surfactant can be preferably employed. In view of low foamability, ease of pH adjustment, etc., a nonionic surfactant is more preferred. Examples of the nonionic surfactant include oxyalkylene polymers such as polyethylene glycol, polypropylene glycol, and polytetramethylene glycol; polyoxyalkylene derivatives (e.g., polyoxyalkylene adducts) such as polyoxyethylene alkyl ether, polyoxyethylene alkyl phenylether, polyoxyethylene alkyl amine, polyoxyethylene fatty acid ester, polyoxyethylene glycerylether fatty acid ester, and polyoxyethylene sorbitan fatty acid ester; and copolymers of plural kinds of oxyalkylene (e.g., diblock type copolymers, triblock type copolymers, random type copolymers, and alternate copolymers). The surfactant can be used singly or in combination of two or more kinds thereof.

Specific examples of the nonionic surfactant include block copolymers of ethylene oxide (EO) and propylene oxide (PO) (diblock type copolymers, PEO (polyethylene oxide)-PPO (polypropylene oxide)-PEO type triblock forms, PPO-PEO-PPO type triblock copolymers, etc.), random copolymers of EO and PO, polyoxyethylene glycol, polyoxyethylene propylether, polyoxyethylene butylether, polyoxyethylene pentylether, polyoxyethylene hexylether, polyoxyethylene octylether, polyoxyethylene-2-ethylhexylether, polyoxyethylene nonylether, polyoxyethylene decylether, polyoxyethylene isodecylether, polyoxyethylene tridecylether, polyoxyethylene laurylether, polyoxyethylene cetylether, polyoxyethylene stearylether, polyoxyethylene isostearylether, polyoxyethylene oleylether, polyoxyethylene phenylether, polyoxyethylene octylphenylether, polyoxyethylene nonylphenylether, polyoxyethylene dodecylphenylether, polyoxyethylene styrated phenylether, polyoxyethylene laurylamine, polyoxyethylene stearylamine, polyoxyethylene oleylamine, polyoxyethylene monolaurate, polyoxyethylene monostearate, polyoxyethylene distearate, polyoxyethylene monooleate, polyoxyethylene dioleate, polyoxyethylene sorbitan monolaurate, polyoxyethylene sorbitan monopalmitate, polyoxyethylene sorbitan monostearate, polyoxyethylene sorbitan monooleate, polyoxyethylene sorbitan trioleate, polyoxyethylene sorbit tetraoleate, polyoxyethylene castor oil, and polyoxyethylene castor wax. Particularly preferred examples of the surfactant include block copolymers of EO and PO (in particular, PEO-PPO-PEO type triblock copolymers), random copolymers of EO and PO, and polyoxyethylene alkyl ether (e.g., polyoxyethylene decylether). As such polyoxyethylene alkyl ether, a substance in which the number of EO moles added is about 1 to 10 (e.g., about 3 to 8) can be preferably employed.

In some embodiments, a nonionic surfactant is preferably used. Use of a nonionic surfactant tends to further enhance performance to reduce haze.

The molecular weight of the surfactant is, e.g., less than 5000, and in view of filterability, cleanability, etc., the molecular weight is preferably 4500 or less, and may be, e.g., less than 4000. In view of interfacial action or the like, the molecular weight of the surfactant is also usually suitably 200 or more, and in view of an effect to reduce haze or the like, the molecular weight is preferably 250 or more (e.g., 300 or more). The more preferred range of the molecular weight of the surfactant may also be varied corresponding to the type of the surfactant. For example, when polyoxyethylene alkyl ether is used as the surfactant, the molecular weight is preferably e.g., less than 2000, more preferably 1900 or less (e.g., less than 1800), even more preferably 1500 or less, and may be 1000 or less (e.g., 500 or less). In addition, for example, when a block copolymer of EO and PO is used as the surfactant, the weight average molecular weight thereof may be, e.g., 500 or more, 1000 or more, and further 1500 or more, 2000 or more, and further 2500 or more. The upper limit of the weight average molecular weight is, e.g., less than 5000, preferably 4500 or less, and may be, e.g., less than 4000, less than 3800, or less than 3500.

As the molecular weight of the surfactant, a molecular weight calculated from a chemical formula may be employed, or a value of a weight average molecular weight derived by GPC (aqueous phase, on polyethylene glycol conversion basis) may be employed. A measurement condition of GPC can employ the same measurement condition as that for the water-soluble polymer as described above. For example, polyoxyethylene alkyl ether preferably employs a molecular weight calculated from a chemical formula, and a block copolymer of EO and PO preferably employs a weight average molecular weight derived by the GPC as described above.

Without particular limitation, in an embodiment where the polishing composition contains a surfactant, the content of the surfactant relative to 100 parts by weight of an abrasive (typically, silica particles) is, in view of cleanability and the like, suitably 20 parts by weight or less, preferably 10 parts by weight or less, more preferably 6 parts by weight or less (e.g., 3 parts by weight or less). In view of better exerting an effect of use of the surfactant, the content of the surfactant relative to 100 parts by weight of an abrasive is suitably 0.001 parts by weight or more, preferably 0.01 parts by weight or more, more preferably 0.1 parts by weight or more, and may be 0.5 parts by weight or more.

<Water>

The polishing composition disclosed herein typically contains water. Examples of water in the polishing composition to be potentially preferably used include ion-exchanged water (deionized water), pure water, ultrapure water, and distilled water. In water to be used, the content of transition metal ions is preferably, e.g., 100 ppb or less in total, in order to avoid inhibiting a function of another component in the polishing composition as much as possible. For example, water can have improved purity by removal of impurity ions by ion-exchange resin, removal of contaminants by a filter, distillation, etc. The polishing composition disclosed herein may further contain an organic solvent that can be uniformly mixed with water (lower alcohol, lower ketone, etc.), as appropriate. In a solvent(s) in the polishing composition, water preferably accounts for 90% by volume or more, and more preferably 95% by volume or more (e.g., 99 to 100% by volume).

<Other components>

The polishing composition disclosed herein may further contain, as appropriate, a known additive that can be used for a polishing composition (e.g., a polishing composition used for a final polishing step of a silicon wafer), such as organic acid (except for the chelating agent (D)), an organic acid salt (except for the chelating agent (D)), inorganic acid, an inorganic acid salt, an antiseptic agent, or an antifungal agent, as long as an effect of the present invention is not significantly inhibited.

The organic acid and salts thereof, and inorganic acid and salts thereof can be used singly or in combination of two or more kinds thereof. Examples of the organic acid include aliphatic acids such as formic acid, acetic acid, and propionic acid; aromatic carboxylic acids such as benzoic acid and phthalic acid; itaconic acid; citric acid; oxalic acid;

tartaric acid; malic acid; maleic acid; fumaric acid; succinic acid; glycolic acid; malonic acid; gluconic acid; lactic acid; and organic sulfonic acid such as methanesulfonic acid. Examples of the organic acid salt include alkali metal salts (sodium salts, potassium salts, etc.) and ammonium salts of organic acid. Examples of the inorganic acid include hydrochloric acid, phosphoric acid, sulfuric acid, phosphonic acid, nitric acid, phosphinic acid, boric acid, and carbonic acid. Examples of the inorganic acid salt include alkali metal salts (sodium salts, potassium salts, etc.) of inorganic acid.

The polishing composition disclosed herein preferably contains substantially no oxidant. This is because when the polishing composition contains an oxidant, supply of the polishing composition to a substrate (e.g., a silicon wafer) can cause oxidation on a surface of the substrate and generate an oxide layer, thereby reducing a polishing removal rate. Specific examples of an oxidant in this context include hydrogen peroxide ($H_2O_2$), sodium persulfate, ammonium persulfate, and sodium dichloroisocyanurate. The phrase that the polishing composition contains substantially no oxidant means not containing an oxidant at least intentionally. Accordingly, when inevitably containing a small amount of an oxidant (e.g., the molar concentration of an oxidant in the polishing composition is 0.001 mole/L or less, preferably 0.0005 mole/L or less, more preferably 0.0001 mole/L or less, even more 0.00005 mole/L or less, particularly preferably 0.00001 mole/L or less) derived from a raw material, a production method, etc., the polishing composition can be encompassed within the concept of a polishing composition containing substantially no oxidant in this context.

<pH>

The pH of the polishing composition disclosed herein is not particularly limited, and suitable pH can be employed corresponding to a substrate, etc. In some embodiments, the pH of the polishing composition is appropriately 8.0 or more, preferably 8.5 or more, more preferably 9.0 or more. Higher pH of the polishing composition tends to lead to increase in a polishing removal rate. Meanwhile, in view of suppressing dissolution of silica particles and reduction in action of mechanical polishing, the pH of the polishing composition is usually, suitably 12.0 or less, preferably 11.0 or less, more preferably 10.8 or less, and even more preferably 10.5 or less.

In the art disclosed herein, the pH of the polishing composition can be known by performing three-point calibration with standard buffers (a phthalate pH buffer with pH 4.01 (25°C), a neutral phosphate pH buffer with pH 6.86 (25°C), and a carbonate pH buffer with pH 10.01 (25°C)) using a pH meter (e.g., a glass-electrode hydrogen ion concentration indicator (model: F-72) manufactured by Horiba, Ltd.), and then inserting a glass electrode into a composition to be measured, leaving it to stand for 2 minutes or more until stabilization and conducting measurement.

<Polishing Slurry>

The polishing composition disclosed herein is typically supplied onto a surface of a substrate in form of a polishing slurry containing the polishing composition, and used for polishing the substrate. The polishing slurry can be, e.g., prepared by diluting any of the polishing compositions disclosed herein (typically, diluting with water). Alternatively, the polishing composition may be used directly as a polishing slurry. Other examples of the polishing slurry containing the polishing composition disclosed herein include a polishing slurry formed by adjusting the pH of the composition.

The content of an abrasive (typically, silica particles) in a polishing slurry is not particularly limited, and is, e.g., 0.005% by weight or more, preferably 0.01% by weight or more, more preferably 0.03% by weight or more, even more preferably 0.06% by weight or more. Increase in the content of an abrasive can provide a higher polishing removal rate. The content is suitably 10% by weight or less, preferably 7% by weight or less, more preferably 5% by weight or less, even more preferably 2% by weight or less, and may be, e.g., 1% by weight or less, 0.5% by weight or less, or 0.4% by weight or less. This facilitates achieving maintenance of a surface quality.

The content of a basic compound in a polishing slurry is not particularly limited. In view of improving a polishing removal rate, the content is usually, suitably 0.0005% by weight or more, preferably 0.001% by weight or more, more preferably 0.003% by weight or more. In view of improving a surface quality (e.g., reduction in haze), etc., the content is suitably less than 0.1% by weight, preferably less than 0.05% by weight, more preferably less than 0.03% by weight (e.g., less than 0.025% by weight, and further, less than 0.01% by weight).

Without particular limitation, in some embodiments, the content of the modified polyvinyl alcohol-based polymer (C1) in a polishing slurry may be, e.g., 0.0001% by weight or more, and is usually, suitably 0.0005% by weight or more, preferably 0.001% by weight or more, and may be, e.g., 0.002% by weight or more, or 0.0025% by weight or more, in view of improving a surface quality, etc. The upper limit of the content of the modified polyvinyl alcohol-based polymer (C1) is not particularly limited, and can be, e.g., 0.05% by weight or less. In view of stability in a concentrate form, a polishing removal rate, cleanability and the like, the content of the modified polyvinyl alcohol-based polymer (C1) in some embodiments is preferably 0.03% by weight or less, more preferably 0.015% by weight or less, even more preferably 0.01% by weight or less. The polishing slurry disclosed herein can be prepared even in an embodiment e.g., where the content of the modified polyvinyl alcohol-based polymer (C1) is 0.008% by weight or less, 0.006% by weight or less, 0.004% by weight or less, or 0.003% by weight or less.

Without particular limitation, in some embodiments, the content of the water-soluble polymer (C2) in a polishing slurry may be, e.g., 0.0001% by weight or more, and is usually, suitably 0.0005% by weight or more, preferably 0.001% by weight or more, and may be, e.g., 0.002% by weight or more, 0.003% by weight or more, or 0.004% by weight or more in view of improving a surface quality, etc. The upper limit of the content of the water-soluble polymer (C2) is not particularly limited, and can be, e.g., 0.1% by weight or less. In view of stability in a concentrate form, a polishing removal rate, cleanability and the like, the content of the water-soluble polymer (C2) in some embodiments is preferably 0.05% by weight or less, more preferably 0.02% by weight or less, even more preferably 0.01% by weight or less, and may be 0.005% by weight or less.

The total content of a water-soluble polymer in the polishing slurry (the total content in presence of two or more kinds of water-soluble polymers) is not particularly limited, and can be, e.g., 0.0001% by weight or more in some embodiments. In view of reduction in haze, etc., the total content is preferably 0.0005% by weight or more, more preferably 0.001% by weight or more, even more preferably 0.002% by weight or more, and may be, e.g., 0.005% by weight or more. The upper limit of the total content is, e.g., 0.5% by weight or less, and in view of a polishing removal rate, etc., it is preferably 0.2% by weight or less, more preferably 0.1% by weight or less, even more preferably 0.05% by weight or less (e.g., 0.02% by weight or less, and further, 0.015% by weight or less).

Without particular limitation, in some embodiments, the content of a chelating agent in a polishing slurry may be, e.g., 0.0001% by weight or more, and is usually, suitably 0.0005% by weight or more, preferably 0.001% by weight or more, and may be 0.0015% by weight or more, or 0.002% by weight or more in view of improving a surface quality, etc. The upper limit of the content of a chelating agent is not particularly limited, and can be, e.g., 0.1% by weight or less. In view of stability in a concentrate form, a polishing removal rate, cleanability and the like, the content of a chelating agent in some embodiments is preferably 0.05% by weight or less, more preferably 0.01% by weight or less, even more preferably 0.008% by weight or less, and may be 0.006% by weight or less.

In presence of a surfactant, the content of the surfactant in a polishing slurry (the total content in presence of two or more kinds of surfactants) is not particularly limited, as long as an effect of the present invention is not significantly prevented. Usually, the content of the surfactant can be, e.g., 0.00001% by weight or more in view of cleanability, etc. In view of reduction in haze, etc., the content is preferably 0.0002% by weight or more, more preferably 0.0003% by weight or more, even more preferably 0.0005% by weight or more. In view of a polishing removal rate, etc., the content is preferably 0.1% by weight or less, more preferably 0.01% by weight or less, even more preferably 0.005% by weight or less (e.g., 0.002% by weight or less).

<Concentrate>

The polishing composition disclosed herein may be a concentrated form (i.e., a concentrate form of a polishing slurry) before supply to a substrate. Such a concentrated form of the polishing composition is advantageous in view of convenience, cost reduction, etc. in production, distribution, storage, etc. The concentration factor is not particularly limited, can be, e.g., about 2-fold to 100-fold in volume, and is usually suitably about 5-fold to 50-fold (e.g., about 10-fold to 40-fold). Such a concentrate can be diluted at a desired timing to prepare a polishing slurry (a working slurry), and can be used in an embodiment of supplying the polishing slurry to a substrate. The dilution can be performed, e.g., by adding water to the concentrate and mixing them.

When the polishing composition (i.e., a concentrate) is diluted and used for polishing, the content of an abrasive in the concentrate can be, e.g., 25% by weight or less. In view of dispersion stability, filterability, etc. of the polishing composition, the content is usually, preferably 20% by weight or less, more preferably 15% by weight or less. In some preferred embodiments, the content of an abrasive may be 10% by weight or less, or 5% by weight or less. In view of convenience and cost reduction, etc. in production, distribution, storage, etc., the content of an abrasive in the concentrate can be, e.g., 0.1% by weight or more, and is preferably 0.5% by weight or more, more preferably 0.7% by weight or more, even more preferably 1% by weight or more.

In some embodiments, the content of a basic compound in the concentrate can be, e.g., less than 15% by weight. In view of storage stability, etc., the content is usually, preferably 0.7% by weight or less, more preferably 0.4% by weight or less. In view of convenience, cost reduction, etc. in production, distribution, storage, etc., the content of a basic compound in the concentrate can also be, e.g., 0.005% by weight or more, preferably 0.01% by weight or more, more preferably 0.02% by weight or more, even more preferably 0.05% by weight or more.

In some embodiments, the total content of a water-soluble polymer(s) in the concentrate can be, e.g., 3% by weight or less. In view of filterability, cleanability, and the like of the polishing composition, the content is usually, preferably 1% by weight or less, more preferably 0.5% by weight or less. In view of convenience, cost reduction, etc. in production, distribution, storage, etc., the content is also usually, suitably 0.001% by weight or more, preferably 0.005% by weight or more, more preferably 0.01% by weight or more.

In some embodiments, the content of a chelating agent in the concentrate can be, e.g., 3% by weight or less. In view of filterability, cleanability, and the like of the polishing composition, the content is usually, preferably 1% by weight or

less, more preferably 0.5% by weight or less. In view of convenience, cost reduction, etc. in production, distribution, storage, etc., the content is also usually, suitably 0.01% by weight or more, preferably 0.05% by weight or more, more preferably 0.1% by weight or more.

In an embodiment where the polishing composition contains a surfactant, the content of a surfactant in the concentrate can be, e.g., 0.25% by weight or less, preferably 0.15% by weight or less, more preferably 0.1% by weight or less, and may be 0.05% by weight or less, or 0.025% by weight or less. The content of a surfactant in the concentrate can also be, e.g., 0.0001% by weight or more, and is preferably 0.001% by weight or more, more preferably 0.005% by weight or more, even more preferably 0.01% by weight or more.

<Preparation of Polishing Composition>

The polishing composition used in the art disclosed herein may be a single-agent type or a multi-agent type such as a two-agent type. For example, the composition may be configured to prepare a polishing slurry by mixing of Part A, which contains at least an abrasive among components of the polishing composition, and Part B, which contains at least a part of the remaining components, and mixing and diluting them at an appropriate timing, as appropriate.

A preparation method of the polishing composition is not particularly limited. For example, a well-known mixing apparatus such as a blade stirrer, an ultrasonic disperser, or a homomixer can be used to mix each component of the polishing composition. An embodiment of mixing these components is not particularly limited, and for example, all components may be mixed at a time or may be mixed in an order set appropriately.

<Application>

The polishing composition disclosed herein can be applied to polishing of substrates with various material qualities and shapes. Examples of materials of the substrates include metals or semimetals such as silicon materials, aluminum, nickel, tungsten, copper, tantalum, titanium, and stainless steel, or alloys thereof; glassy substances such as quartz glass, aluminosilicate glass, and glassy carbon; ceramic materials such as alumina, silica, sapphire, silicon nitride, tantalum nitride, and titanium carbide; compound semiconductor substrate materials such as silicon carbide, gallium nitride, and gallium arsenide; and resin materials such as polyimide resins. Among these, a plurality of materials may form a substrate. The shape of a substrate is not particularly limited. The polishing composition disclosed herein can be applied to polishing of a substrate having a plane that has, e.g., a plate shape or a polyhedron shape, or polishing of an end of a substrate (e.g., polishing of a wafer edge).

The polishing composition disclosed herein can be particularly preferably used for polishing of a surface formed of a silicon material (typically, polishing of a silicon wafer). Specific examples of the silicon material include silicon single crystal, amorphous silicon, and polysilicon. The polishing composition disclosed herein can be particularly preferably used for polishing of a surface formed of silicon single crystal (e.g., polishing of a silicon wafer).

The polishing composition disclosed herein can be preferably applied to a polishing step of a substrate (e.g., a silicon wafer). The substrate may be subjected to common treatment that can be applied to a substrate in a step upstream of a polishing step, such as lapping or etching, before a polishing step with the polishing composition disclosed herein.

The polishing composition disclosed herein is effective for use in a final step or an immediately preceding polishing step of a substrate (e.g., a silicon wafer), and use in a final polishing step is particularly preferred. The final polishing step in this context refers to a last polishing step (i.e., a step preceding no further polishing) in a production process of an object. The polishing composition disclosed herein may also be used for a polishing step at the upstream relative to a final polishing (that refers to a stock polishing step between a rough polishing step and a last polishing step, typically includes at least a primary polishing step, and may further include a secondary, tertiary or more-order polishing step(s)), e.g., a polishing step performed just before final polishing.

The polishing composition disclosed herein is effective in application to polishing (typically, final polishing or the preceding polishing thereof) of e.g., a silicon wafer prepared to have a surface with a surface roughness of 0.01 nm to 100 nm through an upstream step. Application to final polishing is particularly preferred. The surface roughness Ra of a substrate can be measured using e.g., the laser scanning surface roughness meter "TMS-3000WRC" manufactured by Schmitt Measurement System Inc.

<Polishing>

The polishing composition disclosed herein can be used for polishing of a substrate e.g., in an embodiment including the following operation. Description will now be made for a preferred embodiment of a method of polishing a silicon wafer as a substrate with use of the polishing composition disclosed herein.

In other words, a polishing slurry containing any of the polishing compositions disclosed herein is provided. Provision of the polishing slurry may contain subjecting the polishing composition to operation such as concentration

adjustment (e.g., dilution), pH adjustment, etc., thereby preparing the polishing slurry. Alternatively, the polishing composition may be directly used as a polishing slurry.

Then, the polishing slurry is supplied to a substrate, and polishing is carried out by a common method. For example, in final polishing of a silicon wafer, typically, a silicon wafer that experienced a lapping step is set in a typical polishing machine, and then the polishing slurry is supplied via a polishing pad of the polishing machine onto a surface to be polished in the silicon wafer. Typically, while the polishing slurry is consecutively supplied, a polishing pad is pushed against a surface to be polished of a silicon wafer and both are relatively moved (e.g., rotatably moved). Through such a polishing step, polishing of a substrate is completed.

A polishing pad used in the polishing step is not particularly limited. For example, polishing pads such as a foamed polyurethane type, a non-woven fabric type, and a suede type can be used. Each polishing pad may or may not contain an abrasive. Usually, a polishing pad containing no abrasive is preferably used.

A substrate polished by using the polishing composition disclosed herein is typically cleaned. Cleaning can be performed using a suitable cleaning liquid. A cleaning liquid to be used herein is not particularly limited. For example, SC-1 cleaning liquid (a mixture solution of ammonium hydroxide ($NH_4OH$), hydrogen peroxide ($H_2O_2$), and water ($H_2O$)), SC-2 cleaning liquid (a mixture solution of HCl, $H_2O_2$, and $H_2O$), an ozone water cleaning liquid, a hydrofluoric acid cleaning liquid, etc., which are common in the art of semiconductors or the like, can be used. For example, temperature of a cleaning liquid can be within the range of room temperature (typically, about 15°C to 25°C) or higher to about 90°C. In view of improving an effect of cleaning, a cleaning liquid at 50°C to 85°C can be preferably used.

As mentioned above, the art disclosed herein may include providing a method of producing a polished material including a polishing step (preferably, final polishing) by any of the aforementioned polishing methods (e.g., a method of producing a silicon wafer) and a polished material (e.g., a silicon wafer) produced by the method.

The items disclosed herein include the followings.

[1] A polishing composition comprising silica particles (A) as an abrasive, a basic compound (B), a water-soluble polymer (C), and a chelating agent (D),

wherein the water-soluble polymer (C) comprises a modified polyvinyl alcohol-based polymer (C1), and
wherein the modified polyvinyl alcohol-based polymer (C1) has an etching rate of 20 nm/h or less, based on etching rate measurement as follows:

(1) prepare a liquid agent for etching rate measurement LE containing 0.175% by weight of a modified polyvinyl alcohol-based polymer and 0.205% by weight of ammonia with the rest filled with water;
(2) prepare a silicon single crystal substrate (having a rectangular shape with 6 cm in length, 3 cm in width, and 775 μm in thickness) by immersion in a cleaning liquid of $NH_4OH$ (29%) : $H_2O_2$ (31%) : deionized water (DIW) = 2:5.3:48 (volume ratio) at 25°C for 1 minute and then in an aqueous hydrogen fluoride (HF) solution (5%) at 25°C for 30 seconds, and measure a weight WO of the silicon single crystal substrate;
(3) immerse the silicon single crystal substrate in the liquid agent LE at 25°C for 40 hours;
(4) remove the silicon single crystal substrate from the liquid agent LE, and clean the silicon single crystal substrate with deionized water (DIW) at 25°C for 10 seconds;
(5) after cleaning, measure a weight W1 of the silicon single crystal substrate; and
(6) calculate an etching rate [nm/h] from a difference between the WO and the W1 and a specific gravity of the silicon single crystal substrate.

[2] The polishing composition according to [1] above, wherein the modified polyvinyl alcohol-based polymer (C1) is one or two or more kinds selected from the group consisting of acetalized polyvinyl alcohol-based polymers, and polyvinyl alcohol-based polymers containing a repeating unit derived from alkyl vinyl ether.
[3] The polishing composition according to [1] or [2] above, wherein the content of the modified polyvinyl alcohol-based polymer (C1) is 0.5 parts by weight or more and 10 parts by weight or less relative to 100 parts by weight of the abrasive.
[4] The polishing composition according to any of [1] to [3] above, further containing a water-soluble polymer (C2) having a chemical structure different from that of the modified polyvinyl alcohol-based polymer (C1), as the water-soluble polymer (C),
wherein the water-soluble polymer (C2) is a nitrogen atom-containing polymer.
[5] The polishing composition according to [4] above, wherein the nitrogen atom-containing polymer is a polymer containing a cyclic amide having an N-(meth)acryloyl group as a monomer unit.
[6] The polishing composition according to any of [1] to [5] above, wherein the chelating agent (D) contains one or two or more kinds selected from the group consisting of aminocarboxylic acid-based chelating agents and organic phosphonic acid-based chelating agents.

[7] The polishing composition according to any of [1] to [6] above, further containing a surfactant (E).
[8] The polishing composition according to any of [1] to [7] above, used for polishing a surface formed of a silicon material.
[9] A concentrate of the polishing composition according to any of [1] to [8] above.
[10] A polishing method comprising polishing a surface formed of a silicon material with use of the polishing composition according to any of [1] to [9] above.

[Examples]

Several examples relating to the present invention will be described below, but the present invention is not intended to be limited to the embodiments shown in the examples. In the following description, "part" and "%" are on a weight basis unless otherwise specified.

<Preparation of Polishing Composition>

(Example 1)

An abrasive, a basic compound, a water-soluble polymer, a chelating agent, a surfactant and deionized water were mixed to prepare a concentrate of a polishing composition according to each example. As the abrasive, colloidal silica with an average primary particle diameter of 25 nm was used. As the basic compound, ammonia was used. As the water-soluble polymer, acetalized polyvinyl alcohol with a Mw of about 9700 (Ac-PVA; acetalization degree: 24 mol%) as the modified polyvinyl alcohol-based polymer (C1) and polyacryloyl morpholine (PACMO) with a Mw of about $35\times10^4$ as the water-soluble polymer (C2) were used. As the chelating agent, ethylenediamine tetrakis(methylene phosphonic acid) (EDTPO) was used. As a surfactant, polyoxyethylene decyl ether with 5 moles ethylene oxide adduct (C10EO5) was used. The concentrate of a polishing composition thus obtained was diluted 40 times by volume ratio with deionized water, thereby providing a polishing composition according to each example containing an abrasive with a content of 0.15%, a basic compound with a concentration of 0.008%, Ac-PVA with a concentration of 0.003%, PACMO with a concentration of 0.005%, EDTPO with a concentration 0.003%, C10EO5 with a concentration of 0.0006%.

(Example 2)

As a chelating agent, triethylenetetramine hexaacetic acid (TTHA) was used instead of EDTPO. The concentration of TTHA was 0.003%. A polishing composition according to this example was prepared in the same manner as in Example 1 except for those described above.

(Example 3)

As a chelating agent, trans-1,2-cyclohexanediamine tetraacetic acid (CyDTA) was used instead of EDTPO. The concentration of CyDTA was 0.003%. A polishing composition according to this example was prepared in the same manner as in Example 1 except for those described above.

(Example 4)

A polishing composition according to this example was prepared in the same manner as in Example 1 except for using no PACMO as the water-soluble polymer (C2).

(Example 5)

As the modified polyvinyl alcohol-based polymer (C1), alkyl-group-modified PVA (hydrophobic modified PVA) having a Mw of about 6100 was used instead of Ac-PVA. The concentration of the hydrophobic modified PVA was 0.003%. A polishing composition according to this example was prepared in the same manner as in Example 1 except for those described above. The alkyl-group-modified PVA used in this example is a random copolymer having vinyl alcohol units and n-propylvinyl ether units at a molar ratio of 85:15.

(Comparative Example 1)

A polishing composition according to this example was prepared in the same manner as in Example 1 except for using no chelating agent.

(Comparative Example 2)

A polishing composition according to this example was prepared in the same manner as in Example 1 except for using no PACMO as the water-soluble polymer (C2) and using no chelating agent.

(Comparative Example 3)

Completely saponified polyvinyl alcohol (PVA) (saponification degree: 98% or more) with a Mw of about $7.0\times 10^4$ was used instead of Ac-PVA. The concentration of PVA was 0.003%. A polishing composition according to this example was prepared in the same manner as in Example 1 except for those described above.

(Comparative Example 4)

A polishing composition according to this example was prepared in the same manner as in Example 1 except for using a butenediol-vinyl alcohol copolymer (BVOH) instead of Ac-PVA, with the concentration of BVOH being 0.003%.

Table 1 shows a summary of a configuration of each example. Furthermore, the etching rate of a water-soluble polymer used in each example was derived based on etching rate measurement. The results thus obtained are shown in the column "Etching rate " in Table 1.

<Evaluation of LPD-N>

[Polishing of Silicon Wafer]

As a substrate, a silicon wafer was prepared by lapping and etching a commercially available silicon single crystal wafer (conduction type: P type; crystal orientation: <100>; COP (crystal originated particle: crystal defect) free) with a diameter of 300 mm that was then subjected to stock polishing under Polishing condition 1 as follows. The stock polishing was performed using a polishing slurry containing 0.6% abrasive (colloidal silica with an average primary particle diameter of 35 nm) and 0.08% tetramethylammonium hydroxide (TMAH) in deionized water.

[Polishing Condition 1]

Polishing machine: single wafer polishing machine manufactured by Okamoto Machine Tool Works, Ltd., model "PNX-332B"
Polishing load: 20 kPa
Rotation speed of platen: 20 rpm
Rotation speed of head (carrier): 20 rpm
Polishing pad: manufactured by Nitta Dupont Incorporated, product name "SUBA400"
Supply rate of polishing slurry: 1.0 L/min
Temperature of polishing slurry: 20°C
Temperature of platen cooling water: 20°C
Polishing time: 2 mins

Using the polishing composition according to each of the examples prepared as described above as a polishing slurry, the silicon wafer after stock polishing was polished under Polishing condition 2 as follows, and then under Polishing condition 3 as below.

[Polishing Condition 2]

Polishing machine: single wafer polishing machine manufactured by Okamoto Machine Tool Works, Ltd., model "PNX-332B"
Polishing load: 16 kPa
Rotation speed of platen: 52 rpm
Rotation speed of head (carrier): 50 rpm
Polishing pad: manufactured by Fujibo Ehime Co., Ltd., product name "POLYPAS275NX"

Supply rate of polishing slurry: 1.5 L/min
Temperature of polishing slurry: 20°C
Temperature of platen cooling water: 20°C
Polishing time: 2 mins

[Polishing Condition 3]

Polishing machine: single wafer polishing machine manufactured by Okamoto Machine Tool Works, Ltd., model "PNX-332B"
Polishing load: 20 kPa
Rotation speed of platen: 52 rpm
Rotation speed of head (carrier): 50 rpm
Polishing pad: manufactured by Fujibo Ehime Co., Ltd., product name "POLYPAS27NX"
Supply rate of polishing slurry: 1.5 L/min
Temperature of polishing slurry: 20°C
Temperature of platen cooling water: 20°C
Polishing time: 2 mins

The polished silicon wafer was removed from the polishing machine, and cleaned with an ozone water cleaning liquid (60 seconds), then SC-1 cleaning liquid and a brush (110 seconds), followed by total three sets of cleaning with an ozone water cleaning liquid (20 seconds) and then a hydrofluoric acid cleaning liquid (15 seconds), and further cleaned with an ozone water cleaning liquid (20 seconds), using a single wafer processing cleaning machine. Then, the silicon wafer was dried.

The number of LPD-N on a silicon wafer surface after cleaning was measured on DC mode using the wafer testing device commercially named "Surfscan SP5" from KLA-Tencor Corporation (current KLA Corporation). The number of LPD-N thus measured was then converted to a relative value based on the number of LPD-N of Comparative Example 1 as 100%. The results thus obtained are shown in the column "LPD-N" in Table 1.

<Evaluation of Polishing Removal Rate>

[Polishing of Silicon Wafer]

Using the polishing composition according to each of the examples prepared as described above as a polishing slurry, a silicon wafer prepared by lapping and etching a commercially available silicon single crystal wafer (conduction type: P type; crystal orientation: <100>; COP (crystal originated particle: crystal defect) free) with a diameter of 300 mm was polished under Polishing condition 4 as follows.

[Polishing Condition 4]

Polishing machine: single wafer polishing machine manufactured by Okamoto Machine Tool Works, Ltd., model "PNX-322"
Polishing load: 10 kPa
Rotation speed of platen: 52 rpm
Rotation speed of head (carrier): 50 rpm
Polishing pad: manufactured by Fujibo Ehime Co., Ltd., product name "POLYPAS275NX"
Supply rate of polishing slurry: 0.75 L/min
Temperature of polishing slurry: 20°C
Temperature of platen cooling water: 20°C
Polishing time: 10 mins

The polished silicon wafer was removed from the polishing machine, immersed in a ozone water cleaning liquid at room temperature for 15 minutes, and cleaned. Then, the silicon wafer was dried with a spin drier.

(Evaluation of Polishing Removal Rate)

On the basis of a difference in wafer weight between before and after the 10 minutes polishing, a polishing removal rate R [cm/min] in each of the examples and the comparative examples was calculated according to the following formulae (a1) to (a3). The polishing removal rate R thus obtained was converted to a relative value based on the polishing removal rate in Comparative Example 1 as 100%. The results thus obtained are shown in the column "Polishing removal rate " in Table 1. If a polishing removal rate (a relative value) is 70% or more, the polishing removal rate is evaluated as sustained.

Formulae:

$$\Delta V = (W0 - W1)/d \qquad (a1)$$

$$\Delta x = \Delta V/S \qquad (a2)$$

$$R = \Delta x/t \qquad (a3)$$

$\Delta V$: change of wafer volume between before and after polishing

WO: wafer weight before polishing [g]

W1: wafer weight after polishing [g]

d: specific gravity of silicon (2.33) [$g/cm^3$]

S: wafer area [$cm^2$]

$\Delta x$: change of wafer thickness between before and after polishing [cm]

t: polishing time [min]

The column "LPD-N/polishing removal rate" in Table 1 shows the ratio of a LPD-N (relative value) to a polishing removal rate (relative value) calculated on the basis of a polishing removal rate (relative value) and a LPD-N (relative value) of each example obtained by the aforementioned method. As the ratio is smaller, LPD-N tends to be more reduced along with a polishing removal rate being sustained.

[Table 1]

Table 1

| | Modified polyvinyl alcohol-based polymer (C1), etc. | | Water-soluble polymer (C2) | Chelating agent | Evaluation | | |
|---|---|---|---|---|---|---|---|
| | Type | Etching rate [nm/hr] | | | LPD-N [%] | Polishing removal rate [%] | LPD-N /polishing removal rate |
| Ex.1 | Ac-PVA | 16 | PACMO | EDTPO | 82 | 120 | 0.68 |
| Ex.2 | | 16 | PACMO | TTHA | 48 | 122 | 0.40 |
| Ex.3 | | 16 | PACMO | CyDTA | 53 | 108 | 0.49 |
| Ex.4 | | 16 | - | EDTPO | 36 | 97 | 0.38 |
| Ex.5 | hydrophobic modified PVA | 5 | PACMO | EDTPO | 49 | 73 | 0.68 |

(continued)

Table 1

| | Modified polyvinyl alcohol-based polymer (C1), etc. | | Water-soluble polymer (C2) | Chelating agent | Evaluation | | |
|---|---|---|---|---|---|---|---|
| | Type | Etching rate [nm/hr] | | | LPD-N [%] | Polishing removal rate [%] | LPD-N /polishing removal rate |
| Comp.Ex.1 | Ac-PVA | 16 | PACMO | - | 100 | 100 | 1.00 |
| Comp.Ex.2 | Ac-PVA | 16 | - | - | 173 | 89 | 1.95 |
| Comp.Ex.3 | PVA | 31 | PACMO | EDTPO | 106 | 103 | 1.03 |
| Comp.Ex.4 | BVOH | 26 | PACMO | EDTPO | 317 | 60 | 5.29 |

As shown in Table 1, Examples 1 to 5, which used a polishing composition containing silica particles, a basic compound, a modified polyvinyl alcohol-based polymer having an etching rate of 20 nm/h or less (the modified polyvinyl alcohol-based polymer (C1)), and a chelating agent, exhibited a remarkably reduced number of LPD-N along with largely sustaining a polishing removal rate, as compared to Comparative Examples 1 to 4, which used a polishing composition without a chelating agent and/or a modified polyvinyl alcohol-based polymer having an etching rate of 20 nm/h or less; Examples 1 to 5 were thus confirmed to achieve a high surface quality. In particular, comparison of Example 1 with Comparative Example 1 and comparison of Example 4 with Comparative Example 2 confirmed that in a system containing a modified polyvinyl alcohol-based polymer having an etching rate of 20 nm/h or less (modified polyvinyl alcohol-based polymer (C1)), addition of a chelating agent reduces LPD-N and improves a polishing removal rate. Moreover, comparison of Examples 1 to 5 with Comparative Examples 3 and 4 confirmed that use of a modified polyvinyl alcohol-based polymer having an etching rate of 20 nm/h or less tends to result in sustaining a polishing removal rate and remarkably reducing the number of LPD-N.

While specific examples of the present invention have been described above in detail, these are only illustrative, and do not limit the scope of the claims. The technologies recited in the claims include various modifications and alternations of the specific examples illustrated above.

## Claims

**1.** A polishing composition comprising silica particles (A) as an abrasive, a basic compound (B), a water-soluble polymer (C), and a chelating agent (D),

wherein the water-soluble polymer (C) comprises a modified polyvinyl alcohol-based polymer (C1), and wherein the modified polyvinyl alcohol-based polymer (C1) has an etching rate of 20 nm/h or less, based on etching rate measurement as follows:

(1) prepare a liquid agent for etching rate measurement LE containing 0.175% by weight of a modified polyvinyl alcohol-based polymer and 0.205% by weight of ammonia with the rest filled with water;
(2) prepare a silicon single crystal substrate having a rectangular shape with 6 cm in length, 3 cm in width, and 775 μm in thickness), by immersion in a cleaning liquid of $NH_4OH$ (29%) : $H_2O_2$ (31%) : deionized water (DIW) = 2:5.3:48 (volume ratio) at 25°C for 1 minute and then in an aqueous hydrogen fluoride (HF) solution (5%) at 25°C for 30 seconds, and measure a weight W0 of the silicon single crystal substrate;
(3) immerse the silicon single crystal substrate in the liquid agent LE at 25°C for 40 hours;
(4) remove the silicon single crystal substrate from the liquid agent LE, and clean the silicon single crystal substrate with deionized water (DIW) at 25°C for 10 seconds;
(5) after cleaning, measure a weight W1 of the silicon single crystal substrate; and
(6) calculate an etching rate [nm/h] from a difference between the W0 and the W1 and a specific gravity of the silicon single crystal substrate.

**2.** The polishing composition according to claim 1, wherein the modified polyvinyl alcohol-based polymer (C1) is one or two or more kinds selected from the group consisting of acetalized polyvinyl alcohol-based polymers, and polyvinyl alcohol-based polymers comprising a repeating unit derived from alkyl vinyl ether.

3. The polishing composition according to claim 1 or 2, wherein the content of the modified polyvinyl alcohol-based polymer (C1) is 0.5 parts by weight or more and 10 parts by weight or less relative to 100 parts by weight of the abrasive.

4. The polishing composition according to claim 1 or 2, further comprising a water-soluble polymer (C2) having a chemical structure different from that of the modified polyvinyl alcohol-based polymer (C1), as the water-soluble polymer (C),
wherein the water-soluble polymer (C2) is a nitrogen atom-containing polymer.

5. The polishing composition according to claim 4, wherein the nitrogen atom-containing polymer is a polymer comprising a cyclic amide having an N-(meth)acryloyl group as a monomer unit.

6. The polishing composition according to claim 1 or 2, wherein the chelating agent (D) comprises one or two or more kinds selected from the group consisting of aminocarboxylic acid-based chelating agents and organic phosphonic acid-based chelating agents.

7. The polishing composition according to claim 1 or 2, further comprising a surfactant (E).

8. The polishing composition according to claim 1 or 2, used for polishing a surface formed of a silicon material.

9. A concentrate of the polishing composition according to claim 1 or 2.

10. A polishing method comprising polishing a surface formed of a silicon material with use of the polishing composition according to claim 1 or 2.

## INTERNATIONAL SEARCH REPORT

International application No.
**PCT/JP2023/027729**

**A. CLASSIFICATION OF SUBJECT MATTER**

***H01L 21/304***(2006.01)i; ***B24B 37/00***(2012.01)i; ***C09G 1/02***(2006.01)i; ***C09K 3/14***(2006.01)i
FI: H01L21/304 622D; H01L21/304 651; B24B37/00 H; C09K3/14 550D; C09K3/14 550Z; C09G1/02

According to International Patent Classification (IPC) or to both national classification and IPC

**B. FIELDS SEARCHED**

Minimum documentation searched (classification system followed by classification symbols)

H01L21/304; B24B37/00; C09G1/02; C09K3/14

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2022/070801 A1 (FUJIMI INCORPORATED) 07 April 2022 (2022-04-07) entire text, all drawings | 1-10 |
| A | JP 2020-27834 A (FUJIMI INCORPORATED) 20 February 2020 (2020-02-20) entire text, all drawings | 1-10 |
| A | WO 2018/216733 A1 (FUJIMI INCORPORATED) 29 November 2018 (2018-11-29) entire text, all drawings | 1-10 |
| A | WO 2018/043504 A1 (FUJIMI INCORPORATED) 08 March 2018 (2018-03-08) entire text, all drawings | 1-10 |
| A | WO 2017/069202 A1 (NITTA HAAS INCORPORATED) 27 April 2017 (2017-04-27) entire text, all drawings | 1-10 |
| A | JP 2019-179837 A (FUJIMI INCORPORATED) 17 October 2019 (2019-10-17) entire text, all drawings | 1-10 |

☐ Further documents are listed in the continuation of Box C.  ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **12 September 2023** | **26 September 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2023/027729**

| Patent document cited in search report | Publication date (day/month/year) | Patent family member(s) | Publication date (day/month/year) |
|---|---|---|---|
| WO 2022/070801 A1 | 07 April 2022 | TW 202220046 A<br>entire text, all drawings | |
| JP 2020-27834 A | 20 February 2020 | (Family: none) | |
| WO 2018/216733 A1 | 29 November 2018 | TW 201900793 A<br>entire text, all drawings | |
| WO 2018/043504 A1 | 08 March 2018 | EP 3508550 A4<br>entire text, all drawings<br>TW 201816059 A<br>CN 109673157 A<br>KR 10-2019-0045249 A | |
| WO 2017/069202 A1 | 27 April 2017 | US 2018/0305580 A1<br>entire text, all drawings<br>EP 3366746 A4<br>TW 201728734 A<br>SG 11201803364W A<br>KR 10-2018-0070586 A<br>CN 108350344 A | |
| JP 2019-179837 A | 17 October 2019 | TW 201942318 A<br>entire text, all drawings<br>KR 10-2020-0128387 A<br>CN 111954705 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2022125594 A
- JP 6185432 B
- JP 6348927 B
- JP 6232243 B